# EUROPEAN PATENT SPECIFICATION

(11) **EP 4 009 740 B1**
(45) Date of publication and mention of the grant of the patent: **19.08.2026**
(21) Application number: 20850532.1
(22) Date of filing: 06.07.2020
(51) Int. Cl.: H05B 3/10, H05B 3/18, H05B 3/48, H05B 3/68, C23C 14/50, C23C 16/46, H10P 72/00, H05B 6/64, H05B 1/02, H05B 3/64, C23C 16/458, C23C 16/511

(54) **HEATER**
HEIZVORRICHTUNG
DISPOSITIF DE CHAUFFAGE

(30) Priority: 02.08.2019 JP 2019142732
(43) Date of publication of application: 08.06.2022
(73) Proprietor: NHK Spring Co., Ltd., Yokohama-shi, Kanagawa 236-0004 (JP)
(72) Inventor: KIDA, Naoya, Yokohama-shi, Kanagawa 236-0004 (JP); TATSUMI, Arata, Yokohama-shi, Kanagawa 236-0004 (JP); SEKIYA, Kenji, Yokohama-shi, Kanagawa 236-0004 (JP); AIKAWA, Naoya, Yokohama-shi, Kanagawa 236-0004 (JP); TAKANASHI, Masaya, Yokohama-shi, Kanagawa 236-0004 (JP)
(74) Representative: dompatent
(86) International application number: PCT/JP2020/026410
(87) International publication number: WO 2021/024672

(56) References cited:
- EP-A1- 3 869 909
- JP-A- S63 166 193
- JP-U- S54 126 146
- JP-U- S6 318 790
- JP-U- S6 318 790
- US-A1- 2015 001 206

## Description

### TECHNICAL FIELD

An embodiment of the present invention relates to a heater.

### BACKGROUND ART

Semiconductor devices are installed in almost all electronic devices and have an important role with respect to their functions. The semiconductor devices utilize the semiconductor properties of silicon, etc. The semiconductor devices are constructed by laminating semiconductor films, insulating films, and conductive films on a substrate followed by patterning these films. These films are deposited by vapor deposition, a sputtering method, a chemical vapor deposition method, or chemical reactions of a substrate and are patterned by a photolithography process. The photolithography process includes the formation of a resist film over a film to be patterned, formation of the resist mask by light exposure and development of the resist film, partial removal of the film by etching, and removal of the resist mask.

The properties of these films are strongly influenced by the conditions under which the films are formed or the conditions under which these films are patterned. One of the conditions is the temperature of the substrate. In many cases, the temperature of the substrate is controlled by adjusting the temperature of a supporting stage (hereinafter, referred to as a stage) for supporting a substrate. A sheath heater is frequently used as a heater for heating the stage in order to uniformly heat the substrate and suppress the temperature distribution in the substrate. For example, patent literature 1 discloses a stage having a plurality of sheath heaters in which an electric heating wire (heater wire) is provided in a metal sheath.

### CITATION LIST

### PATENT LITERATURE

Patent Literature 1: Japanese Laid Open Patent No. 2009 - 91660
Patent Literature 2: JP S63 18790 U

### SUMMARY OF INVENTION

### TECHNICAL PROBLEM

In order to improve the uniformity of the temperature distribution in a substrate, a stage provided with a high density of heaters is required. Further, reducing the diameter of the heater in order to provide a high density of heaters on the stage is a problem. Furthermore, it is an object to improve the reliability of the heater with a reduced diameter so that the heater is not damaged or the heating wire in the heater is not broken as the diameter of the heater is reduced.

One of objects of embodiments of the present invention is to provide a sheath heater having improved reliability and a reduced diameter, to provide a stage provided with a heater for precisely controlling the temperature of the substrate.

### SOLUTION TO PROBLEM

One embodiment of the present invention is a heater according to claim 1.

In another embodiment, the lid member is formed of one member having a predetermined thickness.

In another embodiment, an inner diameter of the lid member may be substantially the same as an outer diameter of the first insulating member, and an outer diameter of the lid member may be substantially the same as an outer diameter of the metal sheath.

In another embodiment, an inner diameter of the metal sheath is substantially the same as an outer diameter of the first insulating member, and the first insulating member may be inserted into the metal sheath.

In another embodiment, the first insulating member has a protruding member, and the lid member may be fitted to the protruding member via the second insulator.

In another embodiment, the protruding member may protrude in a direction opposite to a direction in which the metal sheath is provided.

In another embodiment, the first insulating member may have a through hole, and the second insulating member may be inserted through the through hole.

In another embodiment, a diameter of the through hole in the top of the first insulating member is different from that of the bottom of the first insulating member.

In another embodiment, the cross-section of the through hole may have a stair shape at a connecting part having different hole diameter, and the second insulating member may be inserted to the connecting part.

In another embodiment, a shape of the heater wire may be strip-shaped.

In another embodiment, the heater wire may have a spiral structure.

In another embodiment, the heater wire may have a double helix structure.

In another embodiment, the second insulator may be a sealant or an adhesive.

In another embodiment, the metal sheath may include aluminum.

In another embodiment, the outer diameter of the metal sheath may be 3.0 mm or more and 6.0 mm or less.

In another embodiment, the lid member may include aluminum.

In another embodiment, an outer diameter of the lid member may be 3.0 mm or more and 6.0 mm or less.

### BRIEF DESCRIPTION OF DRAWINGS

FIG. 1A is a cross-sectional view showing a configuration of a heater according to an embodiment of the present invention.
FIG. 1B is a cross-sectional view showing a configuration of a heater according to an embodiment of the present invention.
FIG. 1C is a cross-sectional view showing a configuration of a heater according to an embodiment of the present invention.
FIG. 1D is a cross-sectional view showing a configuration of a heater according to an embodiment of the present invention.
FIG. 1E is a cross-sectional view showing a configuration of a heater according to an embodiment of the present invention.
FIG. 1F is a cross-sectional view showing a configuration of a heater according to an embodiment of the present invention.
FIG. 2A is a cross-sectional view showing a manufacturing method of a heater according to an embodiment of the present invention.
FIG. 2B is a cross-sectional view showing a manufacturing method of a heater according to an embodiment of the present invention.
FIG. 2C is a cross-sectional view showing a manufacturing method of a heater according to an embodiment of the present invention.
FIG. 2D is a cross-sectional view showing a manufacturing method of a heater according to an embodiment of the present invention.
FIG. 3 is a diagram showing a flowchart for explaining a manufacturing method of a heater according to an embodiment of the present invention.
FIG. 4A is a cross-sectional view showing a configuration of a heater and a manufacturing method of a heater according to an embodiment of the present invention.
FIG. 4B is a cross-sectional view showing a configuration of a heater and a manufacturing method of a heater according to an embodiment of the present invention.
FIG. 4C is a cross-sectional view showing a configuration of a heater and a manufacturing method of a heater according to an embodiment of the present invention.
FIG. 4D is a cross-sectional view showing a configuration of a heater and a manufacturing method of a heater according to an embodiment of the present invention.
FIG. 5 is a diagram showing a flowchart for explaining a manufacturing method of a heater according to an embodiment of the present invention.
FIG. 6A is a perspective view and a top view showing a configuration of a stage according to an embodiment of the present invention.
FIG. 6B is a perspective view and a top view showing a configuration of a stage according to an embodiment of the present invention.
FIG. 7A is a cross-sectional view showing a configuration of a stage according to an embodiment of the present invention.
FIG. 7B is a cross-sectional view showing a configuration of a stage according to an embodiment of the present invention.
FIG. 8A is a cross-sectional view showing a configuration of a stage according to an embodiment of the present invention.
FIG. 8B is a cross-sectional view showing a configuration of a stage according to an embodiment of the present invention.
FIG. 9 is a top view showing a configuration of a stage according to an embodiment of the present invention.
FIG. 10A is a cross-sectional view showing a configuration of a heater according to an embodiment of the present invention.
FIG. 10B is a cross-sectional view showing a configuration of a heater according to an embodiment of the present invention.
FIG. 11A is a cross-sectional view showing a configuration of a heater according to an embodiment of the present invention.
FIG. 11B is a cross-sectional view showing a configuration of a heater according to an embodiment of the present invention.
FIG. 12A is a cross-sectional view showing a configuration of a heater according to an embodiment of the present invention.
FIG. 12B is a cross-sectional view showing a configuration of a heater according to an embodiment of the present invention.
FIG. 13 is a schematic cross-sectional view of a film processing device provided with a stage according to an embodiment of the present invention.
FIG. 14 is a schematic cross-sectional view of a film forming device provided with a stage according to an embodiment of the present invention.
FIG. 15 is a schematic cross-sectional view of a film forming device provided with a stage according to an embodiment of the present invention.
FIG. 16 is a schematic cross-sectional view of a film forming device provided with a stage according to an embodiment of the present invention.

### DESCRIPTION OF EMBODIMENTS

Hereinafter, each embodiment of the invention disclosed in the present application is described with reference to the drawings. However, the present invention is defined only by the appended claims.

For the sake of clarity of description, although the drawings may be schematically represented with respect to widths, thicknesses, shapes, and the like of the respective parts compared with actual embodiments, they are merely an example and do not limit the interpretation of the present invention. In addition, in the specification and each of the drawings, components having the same functions as those described with reference to the preceding drawings are denoted by the same reference numerals, and a duplicate description thereof may be omitted. Although an explanation may be provided using the phrase upward or downward for convenience of explanation, upward or downward each indicates the direction when using the heater unit (when mounting a substrate).

In this specification and the drawings, the same reference numerals are used when the same or similar structures are collectively expressed, while a small letter is further added thereto when these structures are distinctively expressed. When a plurality of parts in a single structure is distinctively expressed, the same reference numeral is used and a hyphen and a natural number are further added.

### 1. First Embodiment

In the present embodiment, a sheath heater 110 according to an embodiment of the present invention is described.

### 1-1. Configuration of Sheath Heater

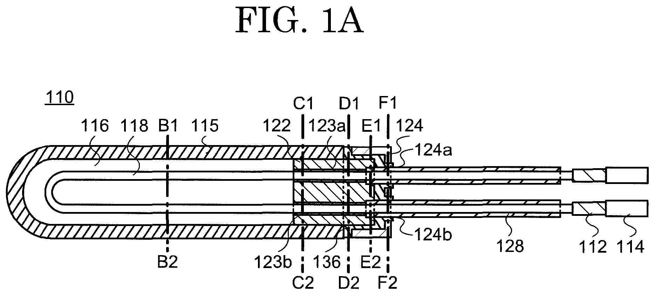

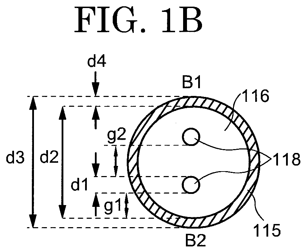

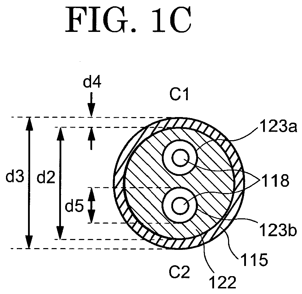

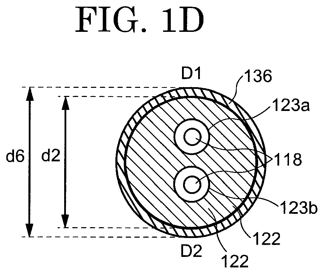

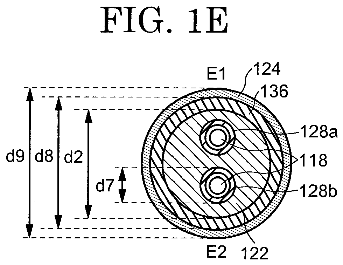

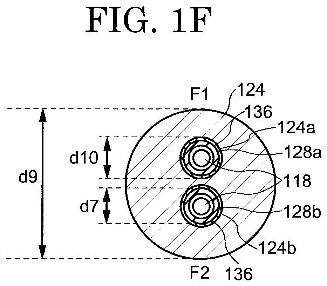

FIG. 1A to 1F are show cross-sectional views of the sheath heater 110. FIG. 1A is a cross-sectional view showing a configuration of the sheath heater 110. FIG. 1B is a cross-sectional view showing a configuration along chain lines B1 and B2. FIG. 1C is a cross-sectional view showing a configuration along chain lines C1 and C2. FIG. 1D is a cross-sectional view showing a configuration along chain lines D1 and D2. FIG. 1E is a cross-sectional view showing a configuration along chain lines E1 and E2. FIG. 1F is a cross-sectional view showing a configuration along chain lines F1 and F2.

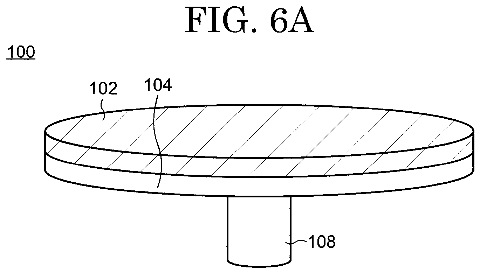

The sheath heater 110 has a function of generating heat by energizing. The sheath heater 110 is provided to heat a second support plate 104 (see FIG. 6A) and a first support plate 102 (see FIG. 6A) of a stage 100 (see FIG. 6A). As a result, a substrate placed on the stage 100 can be heated.

As shown in FIG. 1A, the sheath heater 110 includes a metal sheath 115, a heater wire 118, a first insulator 116, a second insulator 136, a first insulating member 122, a lid member 124, a second insulating member 128, a pair of lead wires 112, and a pair of terminals 114. A mono-terminal type sheath heater 110 is exemplified in FIG. 1A. In the present specification and the like, although the configuration of the sheath heater 110 according to an embodiment of the present invention will be described by taking the mono-terminal type sheath heater 110 as an example, the same configuration as the sheath heater 110 according to an embodiment of the present invention may be applied to a bi-terminal type sheath heater. In the cross section of FIG. 1A, the right side is referred to as the top part and the left side is referred to as the bottom part.

The metal sheath 115 has a cylindrical shape in which a first end part (closed end) is closed, and a second end part (open end) is opened. In the present specification and the like, an example is exemplified in which the shape of the tip of the metal sheath 115 is a semicircular shape but the shape is not limited to this example. For example, the shape of the tip of the metal sheath 115 may be a planar shape or a conical shape. Any shape may be used as long as it is capable of heating the second support plate 104 to be described later (see FIG. 6A) and the first support plate 102 (see FIG. 6A).

The heater wire 118 is folded in the metal sheath 115 and is arranged to reciprocate in the cylindrical axial direction of the metal sheath 115, both ends of which are taken out from the second end part (open end) of the metal sheath 115. That is, one heater wire 118 is arranged so as to be a two-axis (two-cores) in most of the cylindrical axial direction of the metal sheath 115, and one of the two axes, its terminal, the other of the two axes and its terminal are taken out from the second end part of the metal sheath 115 (open end). Further, one and the other of the two axes of one heater wire 118 are arranged so as to be substantially parallel or parallel to the cylindrical axial direction of the metal sheath 115. At least a part of one of the two axes of one heater wire 118 and at least a part of the other of the two axes may be arranged so as to be substantially parallel or parallel to the cylindrical axial direction of the metal sheath 115. Further, the heater wire 118 is arranged with a gap in the metal sheath 115. The heater wire 118 includes a heating wire and a non-heating wire.

The heater wire 118 and the metal sheath 115 are insulated by the first insulator 116 provided in the gap. That is, the heater wire 118 is surrounded by the first insulator 116, whereas the first insulator 116 is surrounded by the metal sheath 115. The first insulator 116 is provided to fill the inside of the sheath 115 between the second end part (open end) and the first end part (closed end) of the metal sheath 115 and reach the vicinity of the second end part (open end). The first insulator 116 may be provided in contact with at least a part of the metal sheath 115, may be provided in contact with at least a part of the heater wire 118, may be provided to insulate the heater wire 118 and the metal sheath 115 without contact with the metal sheath 115, or may be provided to insulate the heater wire 118 and the metal sheath 115 without contact with the heater wire 118. That is, the first insulator 116 may be provided so as to insulate the heater wire 118 and the metal sheath 115.

The first insulating member 122 is provided at the top of the first insulator 116. The first insulating member 122 is in contact with at least a part of the top of the first insulator 116 and the inside of the metal sheath 115 and is provided so as to protrude from the top of the metal sheath 115. The first insulating member 122 has at least a first through hole 123a and a second through hole 123b. One end of the heater wire 118 taken out from the second end part (open end) of the metal sheath 115 is inserted into the first through hole 123a, and the other end is inserted into the second through hole 123b. Therefore, both ends of the heater wire 118, with respect to the first insulating member 122, are inserted from the side where the first insulator 116 is arranged and taken out from the side where the first insulator 116 is not arranged. In this case, at least a part of the first through hole 123a and at least a part of the second through hole 123b may be provided substantially parallel or parallel to the cylindrical axes of the metal sheath 115. At least a part of the heater wire 118 inserted through the first through hole 123a and the second through hole 123b may also be provided substantially parallel or parallel to the cylindrical axes of the metal sheath 115. Further, at least a part of the first through hole 123a and at least a part of the second through hole 123b may be provided substantially parallel or parallel to at least a part of the heater wire 118 inserted through the first through hole 123a and the second through hole 123b. The first insulating member 122 may also be referred to as a protective tube or an insulating tube, and the like.

In this case, in the first through hole 123a and the second through hole 123b, the hole diameter on the top part side of the first insulating member 122 differs from the hole diameter on the bottom part side of the first insulating member 122. For example, as shown in FIG. 1A, the hole diameter of the top part side of the first insulating member 122 is larger than the hole diameter of the bottom part side of the first insulating member 122. That is, the first through hole 123a and the second through hole 123b are formed with the hole diameter on the bottom part side of the first insulating member 122 from the side of the first insulating member 122 in contact with the first insulator 116 to a predetermined length and are formed with the hole diameter on the top part side of the first insulating member 122 from the predetermined length to the top part side of the first insulating member 122. Thus, in a cross-section as shown in FIG. 1A, the first through hole 123a and the second through hole 123b have a step shape. In the first through hole 123a and the second through hole 123b, the hole diameter on the top part side of the first insulating member 122 is larger than the hole diameter on the bottom part side of the first insulating member 122, whereby the first through hole 123a serves as a stopper for stopping the second insulating member 128, which will be described later, at the step shaped part.

At the top part side of the first insulating member 122, one of the two second insulating members 128 is inserted through the first through hole 123a and is provided in contact with the step shaped part of the first through hole 123a. The other of the two second insulating members 128 is inserted into the second through hole 123b and is provided in contact with the step shaped part. The second insulating member 128 has a through hole. One end of the heater wire 118 taken out from the first through hole of the first insulating member 122 is inserted into one of the two second insulating members 128, the other end of the heater wire 118 taken out from the first through hole of the first insulating member 122 is inserted into the other of the two second insulating members 128. Therefore, both ends of the heater wire 118, with respect to the two second insulating members 128, are inserted from the side where the first insulating member 122 is arranged and are taken out from the side where the first insulating 122 is not arranged. In this case, the two second insulating members 128 may be provided substantially parallel or parallel to the cylindrical axis of the metal sheath 115, and a part of the two second insulating members 128 may be provided substantially parallel or parallel to the cylindrical axis of the metal sheath 115. The heater wire 118 inserted into the two second insulating members 128 may also be provided substantially parallel to the cylindrical axis of the metal sheath 115, and a part of the heater wire 118 may be provided substantially parallel or parallel to the cylindrical axis of the metal sheath 115. The outer diameter of the second insulating member 128 is preferably smaller than the outer diameter of the first insulating member 122 and equal to the hole diameter of the top part of the first through hole 123a and the hole diameter of the second through hole 123b of the first insulating member 122. Furthermore, the length of the second insulating member 128 is a length protruding from the position where the lid member 124 is provided.

The second insulator 136 is provided in contact with a part of the metal sheath 115, a part of the first insulating member 122, a part of the inside of the lid member 124, and a part of the second insulating member 128. The second insulator 136 connects a part of the metal sheath 115, a part of the first insulating member 122, a part of the inside of the lid member 124, and the second insulating member 128. The second insulator 136 may be provided to protrude from the lid member 124 opposite the side connecting the lid member 124 and the metal sheath 115. The second insulator 136 is sometimes referred to as a sealant or an adhesive, and the like. The second insulator 136 prevents entry of moisture and a solvent into the sheath heater 110 and suppresses expansion and deterioration of the first insulator 116.

The lid member 124 is connected to a part of the metal sheath 115, a part of the first insulating member 122, and the second insulator member 128 via the second insulator 136. The lid member 124 has an inwardly recessed structure. The recessed part of the lid member 124 has at least two holes. In the sheath heater 110 according to an embodiment of the present invention, for example, the recessed part of the lid member 124 has two holes, such as a first hole 124a and a second hole 124b. One of the two second insulating members 128 is inserted through the first hole 124a, and the other of the two second insulating members 128 is inserted through the second hole 124b. The hole diameter of the first hole 124a and the second hole 124b is larger than the outer diameter of the second insulating member 128 and is preferably equal to the hole diameter of the top part side of the first through hole 123a and the hole diameter of the second through hole 123b of the first insulating member 122. The lid member 124 is arranged parallel to at least a part of the metal sheath 115, the first insulating member 122, and the second insulating member 128.

The lid member 124 has a concave part and is constructed of a single member having a predetermined thickness, so that the outer diameter of the lid member 124 can be the same diameter as or substantially the same diameter as the outer diameter of the metal sheath 115. Therefore, it is possible to provide the sheath heater 110 according to an embodiment of the present invention with a uniform or substantially uniform outer diameter (thickness) by approximately matching the thickness of two or more members.

A pair of lead wires 112 are connected to both ends of the heater wire 118. A pair of terminals 114 is connected to the lead wire 112. A pair of terminals 114 may be connected to both ends of the heater wire 118 without passing through the lead wire 112.

As shown in FIG. 1B, FIG. 1C, FIG. 1D, FIG. 1E, and FIG. 1F, the outside diameter of the heater wire 118 is d1, the inside diameter and outside diameter of the metal sheath 115 are d2 and d3, the thickness of the metal sheath 115 is d4, the diameter of the first through hole 123a and the second through hole 123b is d5, the diameter of the second insulator 136 in the cross section of the configuration along the chain lines D1 and D2 is d6, the outside diameter of a second insulating member 128a and a second insulating member 128b is d7, the diameter of the second insulator 136 in the cross section of the configuration along the chain lines E1 and E2 is d8, the outside diameter of the lid member 124 is d9, the diameter of the second insulator 136 in the cross section of the configuration along the chain lines F1 and F2 is d10, the distance between the heater wires 118 is g1, and the distance between an external wall of the heater wire 118 and an internal wall of the metal sheath 115 is g2. The outer diameter of the first insulating member 122 is also d2. Furthermore, the outer diameter d3 of the metal sheath 115, the diameter d6 of the second insulator 136 in the cross section of the configuration along the chain lines D1 and D2, and the outer diameter d9 of the lid member 124 have the same diameter or substantially the same diameter. The diameter d8 of the second insulator 136 in the cross section of the configuration along the chain lines E1 and E2 is also the inner diameter of the lid member 124. The predetermined thickness of the lid member 124 is (d9-d8)/2, and the predetermined thickness (d9-d8)/2 of the lid member 124 is thinner than the thickness of the metal sheath 115. FIG. 1B, FIG. 1C, FIG. 1D, FIG. 1E, and FIG. 1F are cross-sectional views showing a cross section perpendicular to the cylindrical axis. The outer diameter d1 of the heater wire 118 can be selected from the range of 0.1 mm or more and 2.0 mm or less. The inner diameter d2 of the metal sheath 115 can be selected from the range of 3.0 mm or more and 4.0 mm or less, and the outer diameter d3 of the metal sheath 115 can be selected from the range of 3.0 mm or more and 6.0 mm or less, respectively. The thickness d4 of the metal sheath 115 can be selected from the range of 0.5 mm or more and 1.0 mm or less. The distance g1 between the metal sheath 115 and each heater wire 118 arranged in the metal sheath 115 can be selected from the range of 0.3 mm or more and 1.0 mm or less, or 0.4mm or more and 1.0mm or less. The distance g2 between the folded part from one end of the heater wire 118 and the folded part from the other end is selected from the range of 0.3 mm or more and 2.0 mm or less, or 0.4 mm or more and 1.0 mm or less. The outer diameter d7 of the second insulating member 128a and the second insulating member 128b can be selected from the range of 1.0 mm or more and 4.5 mm or less.

A conductor that generates Joule heat by energizing can be used for the heater wire 118. Specifically, a metal selected from tungsten, tantalum, molybdenum, platinum, nickel, chromium, and cobalt, or an alloy containing these metals, and the like can be used. The alloy includes an alloy of nickel and chromium, an alloy containing nickel, chromium, and cobalt, and the like.

The first insulator 116 is provided to prevent the heater wire 118 from shorting in contact with the metal sheath 115. The material used for the first insulator 116 may be selected from an insulating material having a thermal conductivity of 10 W/mK or more and 200 W/mK. By using such a material, it is possible to efficiently transfer the thermal energy generated by the heater wire 118 to the metal sheath 115. Examples of the first insulator 116 include magnesium oxide, aluminum oxide, boron nitride, and aluminum nitride.

The metal sheath 115 includes a metal which can be selected from a metal having a thermal conductivity of 10 W/mK or more and 430 W/mK or less. By selecting such a metal, it is possible to efficiently transfer the thermal energy generated by the heater wire 118 to the first support plate 102 and the second support plate 104. The metal preferably has a thermal expansion ratio of 5×10⁻⁶ 1/K or more and 25×10⁻⁶ 1/K or less. Thus, it is possible to suppress the deformation due to thermal expansion, and it is possible to provide the highly reliable sheath heater 110. Specifically, metals or alloys such as aluminum, titanium, and stainless steel can be used for the metal sheath 115.

For example, a fluorine-based adhesive, an epoxy-based adhesive or a silicone-based adhesive and the like can be used for the second insulator 136.

The first insulating member 122 is formed from a material containing aluminum oxide, zirconium oxide, magnesium oxide, aluminum nitride or silicon oxide, and the like.

A material similar to the metal sheath 115, and a member having similar properties to the metal sheath 115 can be used for the lid member 124.

For example, an insulating tube formed of vinyl chloride, silicon rubber, fluorine-based polymer, polyimide, a fabric of glass fiber or ceramic fiber, or the like can be used for the second insulating member 128.

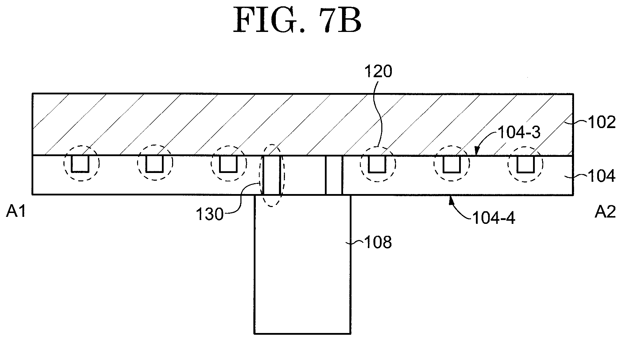

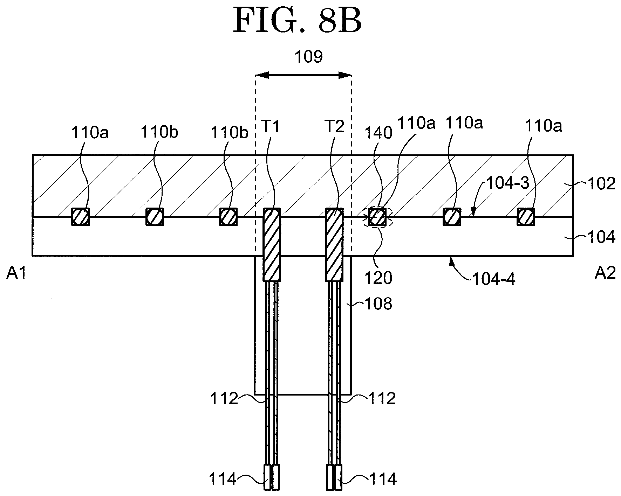

There is no restriction on the shape of the cross-section perpendicular to the cylindrical axis of the sheath heater 110, and it is possible to use the sheath heater 110 having various structures. For example, it may have a circular shape as shown in FIG. 1B or may have a polygonal shape such as the grooves shown in FIGS. 7B and 8B to be described later and may have an elliptical shape although an illustration is omitted. When the cross-sectional shape is a circular shape, since the force required for deformation does not depend on the direction of bending, it is possible to bend the sheath heater 110 easily in any direction. Therefore, it is possible to easily arrange the sheath heater 110 in the grooves formed in the first support plate 102 or the second support plate 104 described later.

A conventional sheath heater has a structure in which an insulating member such as an insulating tube, for example, is connected to a pair of heater wires taken out from the open end of the metal sheath in order to separate the distance between one heater wire and the other heater wire and maintain the distance therebetween. In addition, lead wires are connected to each of the heater wires, and the pair of lead wires is bundled with the insulating members such as an insulating tube. At least a part of such a structure is referred to as a fastener. Moreover, the conventional sheath heater has a structure in which the structure described above is, for example, inserted into a stair shaped cylindrical member having two steps, and the stair shaped cylindrical member having two steps and the metal sheath are connected by brazing. Therefore, the conventional sheath heater is a heater having a thick diameter at least due to the fastener and the stair shaped cylindrical member.

On the other hand, the sheath heater according to an embodiment of the present invention does not include a fastening part, and a stair shaped cylindrical member included in the conventional sheath heater. In the sheath heater 110 according to an embodiment of the present invention, a pair of the heater wires 118 taken out from the open end of the metal sheath 115 is surrounded by the first insulating member 122 which is thinner than the outer diameter of the metal sheath 115 and the second insulating member 128 which is thinner than the outer diameter of the metal sheath 115, and the metal sheath 115 has a structure connected to the lid member 124, wherein the lid member 124 is inserted through the second insulating member 128 and has the outer diameter equivalent to the outer diameter of the metal sheath 115 by the second insulator 136.

In the sheath heater according to an embodiment of the present invention, the lid-shaped member 124 having a recessed part is composed of one member having a predetermined thickness, so that the outer diameter of the lid-shaped member 124 is the same as the outer diameter or approximately the same of the metal sheath 115 diameter. Therefore, the sheath heater 110 according to an embodiment of the present invention does not include the fastening part and the stair shaped cylindrical member which the conventional sheath heater has, and can have a uniform or substantially uniform outer diameter (thickness) by roughly matching the thickness of the two or more members. Therefore, the sheath heater 110 can be formed thinner. By using the sheath heater 110 having a thin diameter, the sheath heater 110 can be laid out at a high density on the stage 100 to be described later. Therefore, by using the sheath heater 110, the temperature distribution on the substrate can be made uniform, and the temperature distribution on the substrate can be further reduced.

### 1-2. Manufacturing Method of Sheath Heater

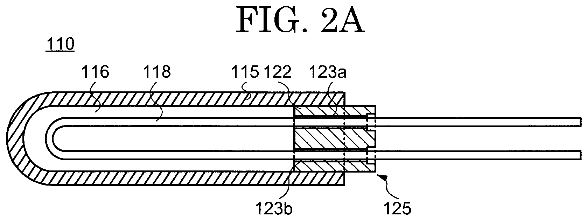

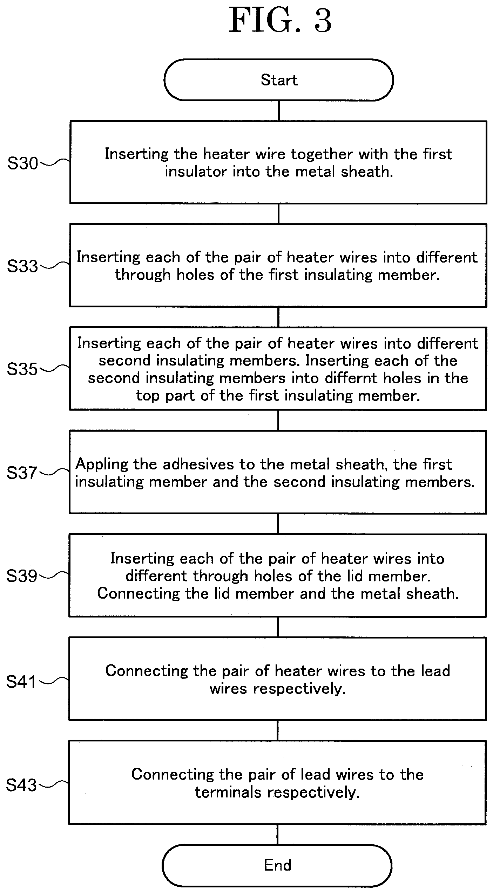

FIG. 2A to FIG. 2D are cross-sectional views showing a manufacturing method of the sheath heater 110. FIG. 3 is a diagram showing a flowchart for explaining a manufacturing method of the sheath heater 110. In FIG. 1A, FIG. 2A to FIG. 2D, the right side is referred to as the top part, and the left side is referred to as the bottom part. Descriptions of the same or similar components as those of FIGS. 1A to 1F may be omitted.

As shown in FIG. 2A and Step 30 (S30) of FIG. 3, when fabrication of the sheath heater 110 is started, the heater wire 118 folded in the metal sheath 115 is inserted into the metal sheath 115 together with the first insulator 116. Both ends of the heater wire 118 are taken out from one end of the metal sheath 115. The length of the pair of the heater wires 118 taken out from one end of the metal sheath 115 is sufficiently longer than the length of the metal sheath 115.

Next, as shown in FIG. 2A and Step 33 (S33) of FIG. 3, both ends of the heater wire 118 taken out from one end of the metal sheath 115 are inserted into the first insulating member 122. More specifically, one of both ends of the heater wire 118 is inserted through the first through hole 123a included in the first insulating member 122, and the other of both ends of the heater wire 118 is inserted through the second through hole 123b included in the first insulating member 122. The first insulating member 122 through which both ends of the heater wire 118 are inserted is fitted into the metal sheath 115 surrounding the first insulator 116 and the heater wire 118. Since the outer diameter of the metal sheath 115 and the outer diameter of the first insulating member 122 are substantially the same or the same diameter, the first insulating member 122 can be fixed to the metal sheath 115 surrounding the heater wire 118 in Step 33. In the present embodiment, a ceramic-based insulating tube of having two through holes is used as the first insulating member 122. In this case, the length of a protruding member 125 of the first insulating member 122 protruding from the metal sheath 115 may be measured. By measuring the length of the protruding member 125, it can be confirmed whether the heater wire 118 is inserted through the first insulating member 122 and whether the first insulating member 122 is properly provided on the metal sheath 115.

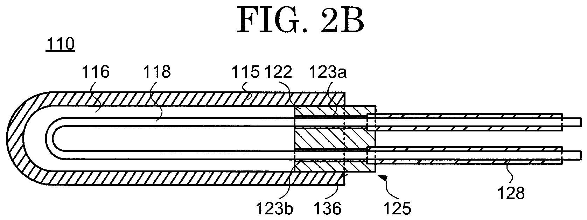

Next, as shown in FIG. 2B and Step 35 (S35) in FIG. 3, one of both ends of the heater wire 118 is inserted into the second insulating member 128a, and the other of both ends of the heater wire 118 is inserted into the second insulating member 128b. The second insulating member 128a is inserted through the top hole of the first through hole 123a and stops at the stair shaped part. The second insulating member 128b is inserted through the top hole of the second through hole 123b and stops at the stair shaped part. The outer diameter of the second insulating member 128 and the hole diameter of the first through hole 123 are substantially the same or the same diameter, and the second insulating member 128a and the second insulating member 128b can be fixed to the first insulating member 122 because the second insulating member 128 stops at the stair shaped part of the first through hole 123 in Step 35. Therefore, it is possible to prevent moisture and solvents from entering the sheath heater 110 through a gap between the second insulating member 128 and the first insulating member 122 due to a misalignment of the second insulating member 128. Therefore, the deterioration of the sheath heater 110 is suppressed, and the long-term reliability of the sheath heater 110 is improved. In the present embodiment, an insulating tube formed from polyimides was used as the second insulating member 128. In addition, an insulating tube having an outer diameter d7 of approximately 2 mm was used as the second insulating member 128.

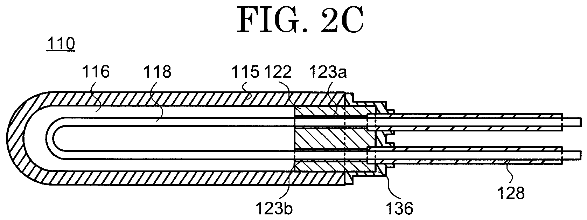

Next, as shown in FIG. 2C and Step 37 (S37) of FIG. 3, the second insulator 136 is applied to the metal sheath 115, the first insulating member 122, and the second insulating member 128. In this embodiment, a fluorine-based adhesive is used for the second insulator 136. The second insulator 136 is in contact with a part of the metal sheath 115, a part of the first insulating member 122, and a part of the second insulating member 128. The second insulator 136 is provided so as to cover the protruding member 125 of the first insulating member 122 and surround the protruding member of the first insulating member 122. FIG. 2C is a schematic view of a cross-section of the sheath heater 110, and the second insulator 136 actually has a curved shape including an inflection point.

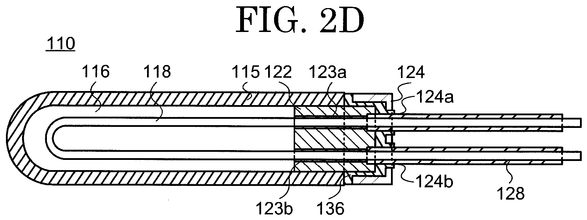

Next, as shown in FIG. 2D and Step 39 (S39) of FIG. 3, the lid member 124 is connected to a part of the metal sheath 115, a part of the first insulating member 122, and a part of the second insulating member 128 by the second insulator 136. One of the two second insulating members 128 is inserted through the first hole 124a of the lid member 124, and the other of the two second insulating members 128 is inserted through the second hole 124b of the lid member 124. Since the lid member 124 has an inwardly recessed structure, the lid member 124 is connected to a part of the metal sheath 115, a part of the first insulating member 122, and a part of the second insulating member 128 so as to cover the protruding member 125 of the first insulating member 122. In Step 39, the lid member 124 is in a state in which the metal sheath 115 is covered with the first insulating member 122 and is fixed to the metal sheath 115 and the first insulating member 122.

Since the outer diameter of the metal sheath 115 and the outer diameter of the first insulating member 122 are substantially the same or the same diameter, and the outer diameter of the lid member 124 and the inner diameter of the first insulating member 122 are substantially the same or the same diameter, the lid member 124 can be fitted to the first insulating member 122 without misalignment.

Furthermore, as shown in FIG. 1A and Step 41 (S41) of FIG. 3, a pair of lead wires 112 is connected to both ends of the heater wire 118. Finally, as shown in FIG. 1A and Step 43 (S43) of FIG. 3, a pair of terminals 114 is connected to a pair of lead wires 112.

The sheath heater 110 is manufactured by the manufacturing method described above. The manufacturing method of the sheath heater 110 described with reference to FIG. 1A, FIG. 2 to FIG. 2D and FIG. 3 is only an example and is not limited to this example. An appropriately selected method may be used as the manufacturing method of the sheath heater 110 as long as the configuration of the sheath heater 110 according to an embodiment of the present invention does not deviate.

A method of connecting a metal sheath, the fastening part, and the stair shaped cylindrical member by brazing was used in the conventional manufacturing method of a sheath heater. Since the sheath heater 110 according to an embodiment of the present invention does not have the fastening part and the stair shaped cylindrical member, in the manufacturing method of the sheath heater 110 according to an embodiment of the present invention, the process of brazing is omitted, and a method of connecting the metal sheath 115 and the lid member 124 by the second insulator 136 (adhesive) can be used. Therefore, the manufacturing method of the sheath heater 110 according to an embodiment of the present invention is relatively easy and has high safety as compared with the conventional manufacturing method. The sheath heater 110 can be formed thinly by manufacturing the sheath heater 110 by the manufacturing method described above.

In the sheath heater 110 according to an embodiment of the present invention, the metal sheath 115 and the lid member 124 are connected by the second insulator 136. The second insulator 136 is an adhesive or a sealant and contains an organic resin. Therefore, even if a force such as bending the sheath heater 110 is applied to the sheath heater 110, the second insulator 136 functions as a soft cushioning material, and it is possible to mitigate the force such as bending. Therefore, in the sheath heater according to an embodiment of the present invention, by connecting the metal sheath 115 and the lid member 124 with the second insulator 136, it is possible to prevent breakage of the sheath heater 110 and a disconnection of the heating wire of the sheath heater 110 having a reduced diameter, and it is possible to provide a highly reliable sheath heater.

### 1-3. Modification of Sheath Heater

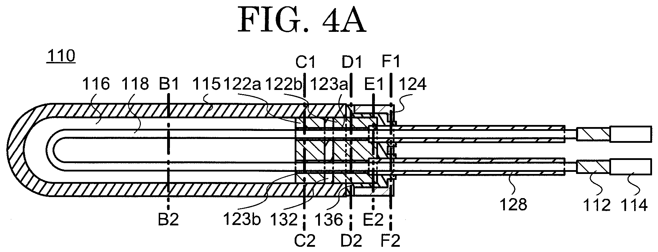

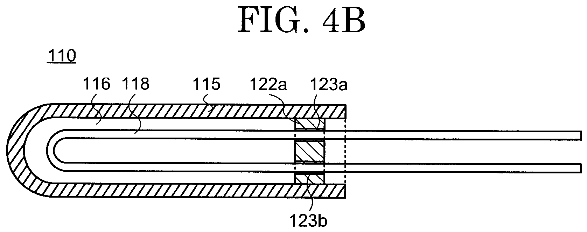

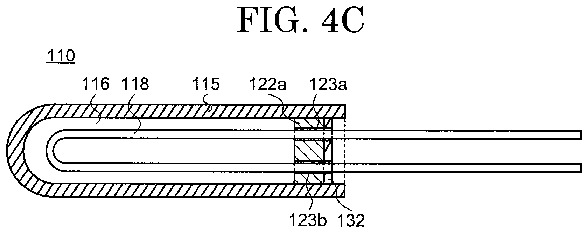

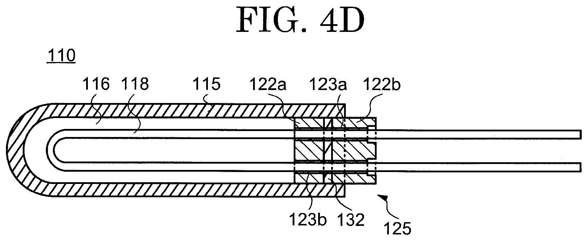

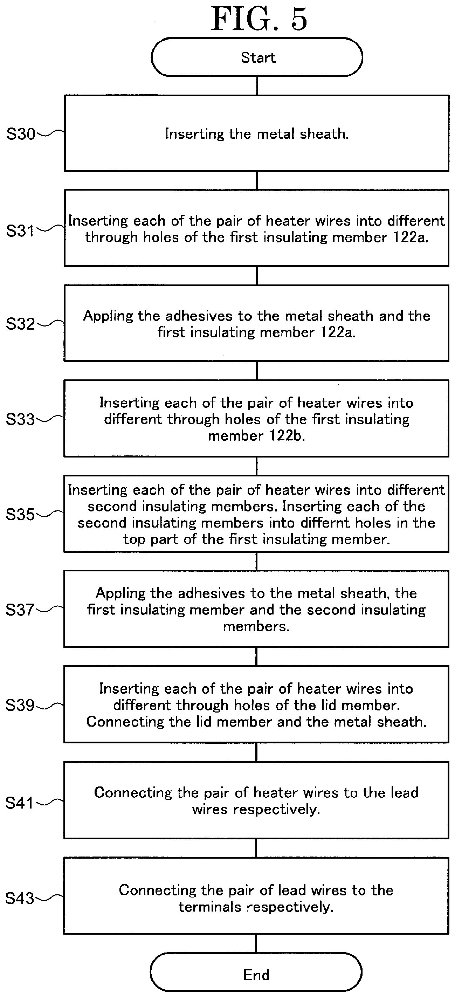

A modification of the sheath heater 110 shown in FIG. 1A is shown in FIG. 4A. FIG. 4A is a cross-sectional view showing the configuration of the sheath heater 110. FIG. 4B, FIG. 4C, and FIG. 4D are diagrams showing manufacturing methods of the sheath heater 110. FIG. 5 is a diagram showing a flowchart for explaining a manufacturing method of the sheath heater 110. The cross-sectional view showing the configuration along the chain lines B1 and B2 in FIG. 4A is similar to FIG 1B. The cross-sectional view showing the configuration along the chain lines C1 and C2 in FIG. 4A is a configuration in which the first insulating member 122 is replaced with a first insulating member 122a in FIG. 1C. The cross-sectional view showing the configuration along the chain lines D1 and D2 in FIG 4A is similar to FIG 1D. The cross-sectional view showing the configuration along the chain lines E1 and E2 in FIG. 4A is the same as in FIG. 1E. The cross-sectional view showing the configuration along the chain lines F1 and F2 in FIG. 4A is the same as FIG. 1F. Descriptions of the same or similar components as those of FIG. 1A to FIG. 3 may be omitted. Similar to FIG. 1A, in FIG. 4A, the right side is referred to as the top part, and the left side is referred to as the bottom part.

The sheath heater 110 shown in FIG. 4A differs from the sheath heater 110 shown in FIG. 1A in that the first insulating member 122 is formed from two members, namely the first insulating member 122a and a first insulating member 122b, and a third insulator is provided between the first insulating member 122a and the first insulating member 122b. Since the sheath heater 110 shown in FIG. 4A is the same as the sheath heater 110 shown in FIG. 1A except for the above, a description thereof will be omitted.

As shown in FIG. 4A, in the sheath heater 110, the first insulating member 122 is formed from two members, namely the first insulating member 122a and the first insulating member 122b, and a third insulator 132 is provided between the first insulating member 122a and the first insulating member 122b with respect to the configuration of the sheath heater 110 shown in FIG. 1A.

The first insulating member 122a is provided on the top part side of the first insulator 116. The first insulating member 122a is in contact with the top of the first insulator 116 and at least a part of the inside of the metal sheath 115 and is provided inside the metal sheath 115 without protruding from the top part side of the metal sheath 115. The outer diameter of the first insulating member 122a is the same as the outer diameter of the first insulating member 122. The first insulating member 122a has at least the first through hole 123a and the second through hole 123b. The hole diameter of the first through hole 123a and the hole diameter of the second through hole 123b differ from the first insulating member 122 in that they are substantially the same or the same at the top part and the bottom part of the first insulating member 122a. In FIG. 4A, the manner in which the heater wire 118 taken out from the second end part (open end) of the metal sheath 115 is inserted into the first insulating member 122a, and the positional relationship among the heater wire 118, the metal sheath 115, the first through hole 123a, and the second through hole 123b with respect to the first insulating member 122a, and the like are the same as those of the configuration of the sheath heater 110 shown in FIG. 1A, and therefore descriptions thereof are omitted. Similar to the first insulating member 122, the first insulating member 122a may be referred to as a protective tube, an insulating tube, or the like.

The third insulator 132 is provided on the top part side of the first insulating member 122a. The third insulator 132 contacts the top part side of the first insulating member 122a and at least a part of the inside of the metal sheath 115 and is provided inside the metal sheath 115 without protruding from the top part side of the metal sheath 115. The third insulator 132 is sometimes referred to as a sealant, an adhesive, or the like. The third insulator 132 connects the first insulating member 122a and the first insulating member 122b. The third insulator 132 prevents entry of moisture and solvent into the sheath heater 110 and suppresses inflation and deterioration of the first insulator 116.

The first insulating member 122b is provided on the top part side of the third insulator 132. The first insulating member 122b contacts the top part side of the third insulator 132 and at least a part of the inside of the metal sheath 115 and is provided so as to protrude from the top part side of the metal sheath 115. Since the first insulating member 122b has the same configuration as the first insulating member 122, a detailed description will be omitted.

A manufacturing method of the sheath heater 110 will be described using FIG. 4B, FIG. 4C, FIG. 4D, and FIG. 5. Step 30 (S30), Step 35 (S35), Step 37 (S37), Step 39 (S39), Step 41 (S41), and Step 43 (S43) are the same as the method described with reference to FIG. 3, and therefore a description thereof is omitted here. A description of the same or similar components as those of FIG. 1 to FIG. 3 may be omitted.

As shown in FIG. 4B and Step 31 (S31) of FIG. 5, both ends of the heater wire 118 taken out from one end of the metal sheath 115 are inserted into the first insulating member 122a. More specifically, one of both ends of the heater wire 118 is inserted through the first through hole 123a included in the first insulating member 122, and the other one of both ends of the heater wire 118 is inserted through the second through hole 123b included in the first insulating member 122. The first insulating member 122 through which both ends of the heater wire 118 are inserted is fitted into the metal sheath 115 surrounding the first insulator 116 and the heater wire 118. Since the outer diameter of the metal sheath 115 and the outer diameter of the first insulating member 122 are substantially the same or the same diameter, the first insulating member 122 can be fixed to the metal sheath 115 surrounding the heater wire 118 in Step 31. In the present embodiment, a ceramic-based insulating tube of having two through holes is used as the first insulating member 122.

Next, as shown in FIG. 4C and Step 32 (S32) of FIG. 5, the third insulator 132 is applied so as to be in contact with a part of the internal wall of the metal sheath 115 and the first insulating member 122a. A material similar to that of the second insulator 136 can be used for the third insulator 132. The third insulator 132 is formed using, for example, a fluorine-based adhesive.

Next, as shown in FIG. 4D and Step 33 (S33) of FIG. 5, both ends of the heater wire 118 taken out from one end of the metal sheath 115 are inserted into the first insulating member 122b. The description of FIG. 4D and Step 33 (S33) of FIG. 5 is the same as the description whereby the first insulating member 122 described in Step 33 (33) of FIG. 3 to the first insulating member 122b are replaced, and a detailed description thereof will be omitted.

As described above, in the sheath heater 110 shown in FIG. 4A, the first insulating member 122 is formed from two members, namely the first insulating member 122a and the first insulating member 122b, and the third insulator 132 is provided between the first insulating member 122a and the first insulating member 122b. The third insulator 132 is an adhesive or a sealant similar to the second insulator 136 and contains an organic resin. Thus, for example, even if a force such as bending the sheath heater 110 is applied to the sheath heater 110, by the configuration including the lid member 124, the second insulator 136, the first insulating member 122b, the third insulator 132 and the first insulating member 122a, the force such as bending can be mitigated at two places or two steps of the vicinity of at least the second insulator 136 and the vicinity of the third insulator 132. Therefore, in the sheath heater according to an embodiment of the present invention, by having a configuration as described above, it is possible to prevent breakage of the sheath heater 110 and a disconnection of the heating wire of the sheath heater 110 having a reduced diameter, and it is possible to provide a highly reliable sheath heater.

### 2.Second Embodiment

In the present embodiment, the stage 100 according to an embodiment of the present invention will be described. Description of the same or similar configuration as that of the first embodiment may be omitted.

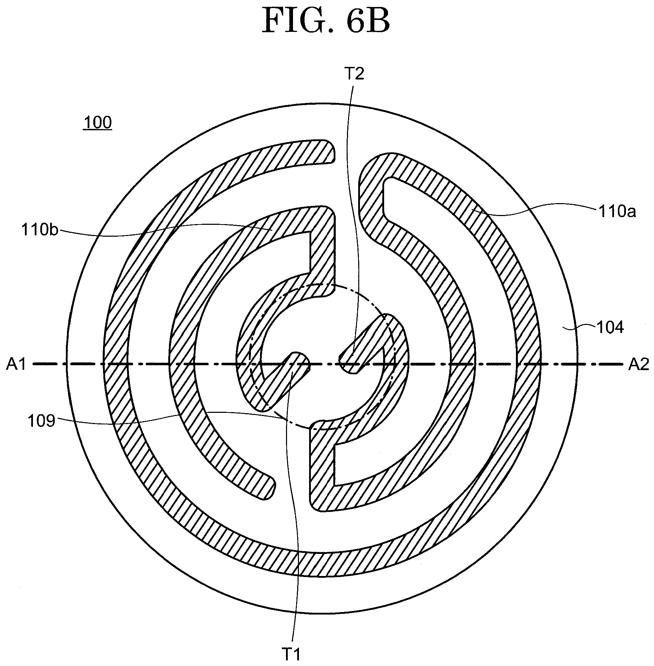

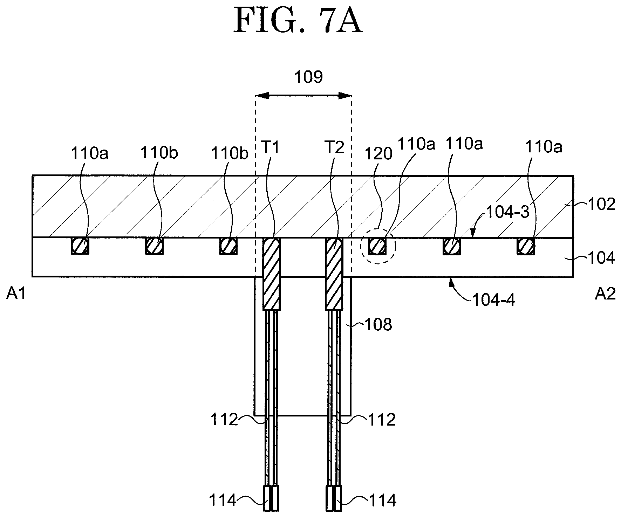

FIG. 6A and FIG. 6B show perspective and top views of the stage 100, respectively. FIG. 7A and FIG. 7B show cross-sectional views along a chain line A1-A2 of FIG. 6B. As shown in FIG. 6A to FIG. 7B, the stage 100 has the first support plate 102, the second support plate 104, a shaft 108, and at least one sheath heater 110. In FIG. 6A to FIG. 7B, an example is demonstrated in which two sheath heaters, namely the first sheath heater 110a and the second sheath heater 110b are provided. Considering the visibility of the drawings, the illustration of the first support plate 102 is omitted in FIG. 6A, and the illustration of the sheath heater 110 is omitted in FIG. 7B.

The first support plate 102 is configured so that the top surface is flat for placing a semiconductor substrate containing silicon or a compound semiconductor, an insulating substrate containing an insulator such as quartz or glass, or the like thereon. The first support plate contains a metal selected from metals having a thermal conductivity of 10 W/mK or more and 430 W/mK or less. By using a metal having a high thermal conductivity, it is possible to efficiently receive the thermal energy generated by the sheath heater 110. Further, it is preferable that the metal has a thermal expansion coefficient of 5 × 10⁻⁶ /K or more and 25 × 10⁻⁶ /K or less. Specific metals satisfying such properties include metals such as titanium, aluminum, and stainless steel. Although not shown, electrostatic chucks for fixing the substrate, a through hole for supplying a gas having a high thermal conductivity, such as helium, between the substrate and the stage 100, or an annular flow path for circulating a liquid medium may be provided on the first support plates 102.

The second support plate 104 is provided below the first support plate 102. The second support plate 104 also includes a metal usable in the first support plate 102. The metal included in the second support plate 104 and the metal included in the first support plate 102 may be the same or different. When these metals are different, these metals can be selected such that the difference in the thermal expansion coefficient of the metals included in the first support plate 102 and the second support plate 104 is 10× 10⁻⁶ /K or less. Thus, it is possible to suppress deformation due to thermal expansion, thereby providing the highly reliable stage 100.

The upper surface 104-3 of the second support plate 104 is bonded to the first support plate 102. The first support plate 102 and the second support plate 104 may be bonded by welding, screwing, or brazing. Brazes used in brazing include silver, copper, and alloys containing zinc, alloys containing copper and zinc, copper containing a trace amount of phosphorus, aluminum and alloys thereof, alloys containing titanium, copper, and nickel, alloys containing titanium, zirconium, and copper, alloys containing titanium, zirconium, copper, and nickel, and the like.

Note that the stage 100 may further have a third support plate (not shown). The third support plate, which is an optional configuration, is provided below the second support plate 104. The third support plate includes a configuration similar to the first support plate 102 or the second support plate 104. The third support plate is bonded to the lower surface 104-4 of the second support plate 104. Similar to the bonding of the first support plate 102 and the second support plate 104, the bonding of the third support plate and the second support plate 104 can also be performed by welding, screwing, brazing, or the like.

The shaft 108 is provided for supporting the first support plate 102 and the second support plate 104. The shaft 108 has a hollow structure in order to store the lead wire 112 for supplying power to the heater wire 118 of the sheath heater 110 described later. When an electrostatic chuck is provided, wiring for supplying power to the electrostatic chuck is also provided within the shaft 108. Although not shown for clarity of the drawings, the shaft 108 may be connected to a rotating mechanism. By connecting the shaft 108 with the rotating mechanism, the stage 100 can be rotated about the long axis of the shaft 108. The shaft 108 is bonded to the second support plate 104 by welding, screwing, brazing, or the like. When the third support plate is used, the shaft 108 is bonded to the third support plate and also supports the third support plate.

The configuration described in the first embodiment can be applied to the sheath heater 110. The sheath heater 110 has a function of generating heat by energizing. The sheath heater 110 is provided to heat the second support plate 104 and the first support plate 102. With this structure, the substrate placed on the stage 100 is heated.

The upper surface 104-3 of the second support plate 104 is provided with a groove (first groove 120) (FIG. 7B), and the first sheath heater 110a and the second sheath heater 110b are provided in the first groove 120 (FIG. 7A). In the examples shown in FIG. 7A and FIG. 7B, the first support plate 102 has a flat lower surface, and the groove is not provided on the lower surface. Therefore, the depth of the first groove 120 is the same as or substantially identical to the outer diameter of the sheath heater 110. Specifically, the depth of the first groove 120 may be greater than 100% of the outer diameter of the sheath heater 110 and equal to or less than 150%, greater than 100% and equal to or less than 120%, or greater than 100% and equal to or less than 110% of the outer diameter of the sheath heater 110. The first groove 120 is formed to be present at a uniform density on the top surface 104-3 in order to reduce the in-plane temperature distribution of the first support plate 102.

The first end part T1 of the first sheath heater 110a is located in a region (region indicated by a dashed circle in FIG. 6B) 109 where the first support plate 102 and the second support plate 104 overlap the shaft 108. The first sheath heater 110a bent at the first end part T1 passes through a through hole 130 (FIG. 7B) formed in the second support plate 104, extends into the shaft 108, and is connected to a heater power supply (not shown) via the lead wire 112 and the terminal 114(FIG. 6A).

Similar to the first end part T1 of the first sheath heater 110a, the first end part T2 of the second sheath heater 110b is also located in the region (region indicated by the dashed circle in FIG. 6B) 109 where the first support plate 102 and the second support plate 104 overlap the shaft 108. The second sheath heater 110b bent at the first end part T2 passes through the through hole 130 (FIG. 7B) formed in the third support plate 106, extends into the shaft 108, and is further connected to the heater power supply (not shown) via the lead wire 112 and the terminal 114 (FIG. 6A).

By applying the configuration described above, it is possible to not only greatly improve the flexibility of the layout of the sheath heater, but also perform more uniform substrate heating.

As described in the first embodiment, the diameter of the conventional sheath heater is thicker than the diameter of the sheath heater 110 provided in the stage 100 according to the embodiment of the present invention. Due to the limitations on the size of the shaft 108 included in the stage, it is difficult to place the end parts of a plurality of sheath heaters in the region 109 when a large number of sheath heaters is used in the stage. As a result, the number of sheath heaters that can be arranged is limited. Therefore, it is impossible to divide the upper surface of the stage into a plurality of segments and to precisely perform temperature control for each segment. Therefore, it is difficult to uniformly heat the substrate.

In contrast, the diameter of the sheath heater 110 provided in the stage 100 according to an embodiment of the present invention is thin. Thus, even when placing a plurality of sheath heaters 110 in the stage 100, it is possible to place the end parts of the plurality of sheath heaters in region 109. Further, the degree of freedom of arrangement of the plurality of sheath heaters 110 is high, by which the upper surface of the stage can be divided into a plurality of segments and precise temperature control can be performed for each segment. Therefore, it is possible to uniformly heat the substrate.

### 3.Third Embodiment

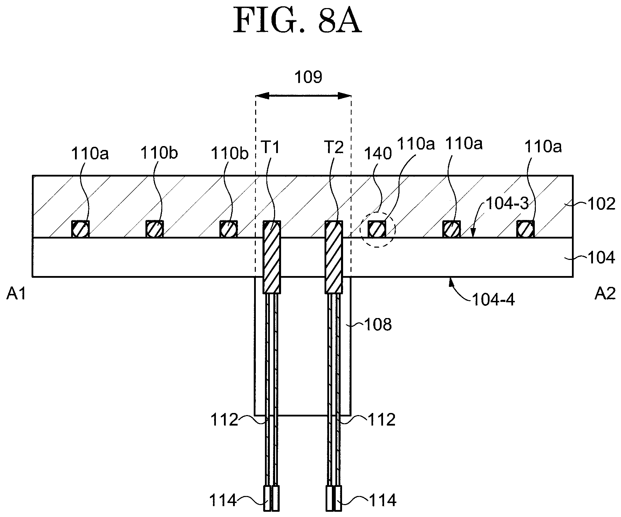

In the present embodiment, a modification of the stage 100 described in the second embodiment will be described with reference to FIG. 8A and FIG. 8B. These figures are cross-sectional views along the dashed lines A1-A2 in FIG. 6B, similar to FIG. 7A. Description of the same or similar configuration as that of the first embodiment or the second embodiment may be omitted.

### 3-1. Modification 1

As shown in FIG. 8A, in modification 1, the groove (first groove 120) is not formed on the upper surface 104-3 of the second support plate 104, and the groove (second groove 140) is formed on the lower surface of the first support plate 102. In the modification 1, the sheath heater 110 is accommodated in the second groove 140. The depth of the second groove 140 is the same as or substantially identical to the outer diameter of the sheath heater 110. Specifically, the depth of the second groove 140 may be greater than 100% and equal to or less than 150%, greater than 100% and equal to or less than 120%, or greater than 100% and equal to or less than 110% of the outer diameter of the sheath heater 110.

In the modification 1, the contact area of the sheath heater 110 and the first support plate 102 can be increased by making the depth of the second groove 140 the same as or substantially identical to the outer diameter of the sheath heater 110. Therefore, it is possible to efficiently transfer the thermal energy generated by the sheath heater 110 to the first support plate 102.

In the modification 1, although a configuration is exemplified in which the depth of the second groove 140 is the same or substantially the same as the outer diameter of the sheath heater 110, the depth of the second groove 140 is not limited thereto. For example, the outer diameter of the sheath heater 110 and the depth of the second groove 140 may be different. If there is a space between the sheath heater 110 and the second groove 140, it is possible to suppress deformation due to thermal expansion of the sheath heater 110. Therefore, a highly reliable stage can be provided.

### 3-2. Modification 2

As shown in FIG. 8B, in the modification 2, the first groove 120 may be formed on the upper surface 104-3 of the second support plate 104, and the second groove 140 may be formed on the lower surface of the first support plate 102. In the modification 2, the sum of the depth of the first groove 120 and the depth of the second groove 140 is the same or substantially the same as the outer diameter of the sheath heater 110. Specifically, the sum of the depth of the first groove 120 and the depth of the second groove 140 may be greater than 100% and equal to or less than 150%, greater than 100% and equal to or less than 120%, or greater than 100% and equal to or less than 110% of the outer diameter of the sheath heater 110.

In the modification 2, the contact area of the sheath heater 110 and the first support plate 102 and the second support plate 104 can be increased by making the sum of the depth of the first groove 120 and the depth of the second groove 140 the same or substantially the same as the outer diameter of the sheath heater 110. Therefore, it is possible to efficiently transfer the thermal energy generated by the sheath heater 110 to the first support plate 102 and the second support plate 104.

In the modification 2, although a configuration is exemplified in which the sum of the depth of the first groove 120 and the depth of the second groove 140 is the same as or substantially the same as the outer diameter of the sheath heater 110, the sum of the depth of the first groove 120 and the depth of the second groove 140 is not limited thereto. For example, the outer diameter of the sheath heater 110 and the sum of the depth of the first groove 120 and the depth of the second groove 140 may be different. If there is a space between the sheath heater 110 and the first groove 120 and the second groove 140, it is possible to suppress deformation due to thermal expansion of the sheath heater 110. Therefore, a highly reliable stage can be provided.

### 4. Fourth Embodiment

In this embodiment, a stage 150 on which a plurality of independently driven sheath heaters 110 is provided will be described. The embodiment shown below is an example of the present embodiment, and there is no limitation to the number of sheath heaters 110 provided on the stage 100. Descriptions of the same or similar components as those of the first to third embodiments may be omitted.

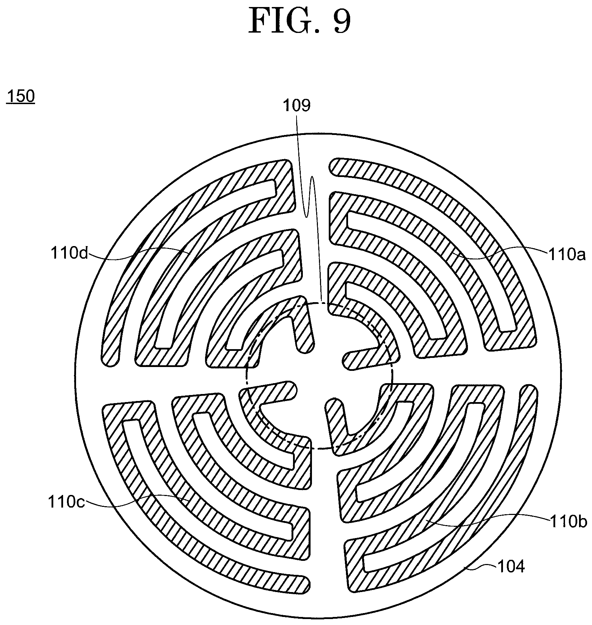

FIG. 9 shows a top view of the stages 150. For the sake of clarity, the first support plate 102 is not shown in FIG. 9. As shown in FIG. 9, four sheath heaters (a first sheath heater 110a, a second sheath heater 110b, a third sheath heater 110c, and a fourth sheath heater 110d) are provided in one quadrant of the stage 150, respectively. That is, four sheath heaters, (the first sheath heater 110a, the second sheath heater 110b, the third sheath heater 110c, and the fourth sheath heater 110d) are provided on the stage 150 with high symmetry. In the example shown in FIG. 9, the first sheath heater 110a to the fourth sheath heater 110d having circular arcs with different radii are arranged.

The first sheath heater 110a to the fourth sheath heater 110d have the same shape and are arranged so that, when one of the first sheath heater 110a to the fourth sheath heater 110d is rotated 90 ° about an axis passing through the center of the second support plate 104, this sheath heater overlaps with the other one of the sheath heaters.

Even when the layout described above is adopted, since the diameters of the plurality of sheath heaters 110 provided in the stage 150 according to an embodiment of the present invention are small, it is possible to place the end parts of the plurality of sheath heaters 110 in the region 109. Moreover, by adopting the layout described above, the plurality of sheath heaters 110 can be placed with high symmetry on the second support plate 104 at a high density. Thus, the temperature of the substrate can be controlled more uniformly and precisely.

### 5. Fifth Embodiment

In the present embodiment, a structure of the sheath heater 110 different from that of the first embodiment will be described. Description of the same or similar configuration as that of the first embodiment may be omitted.

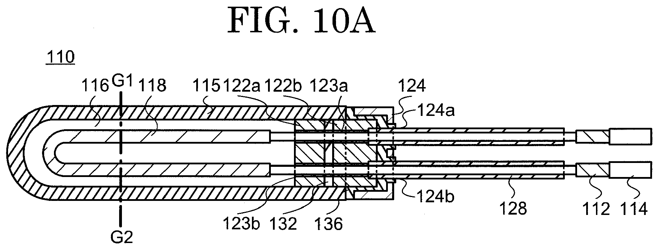

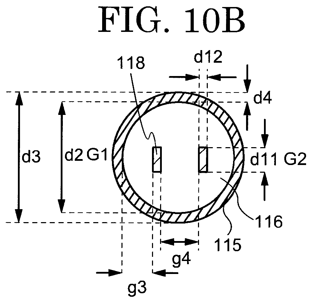

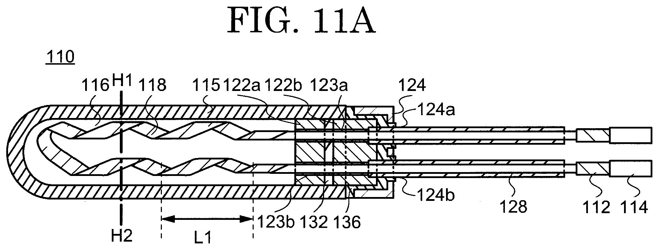

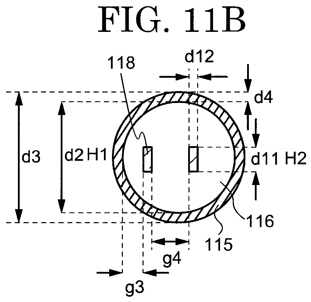

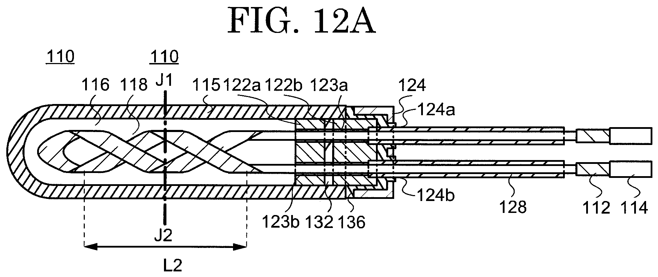

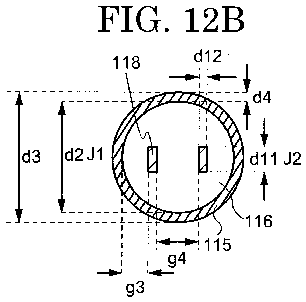

There is no limitation to the sheath heater 110 that can be used in the stage 100 according to the present embodiment, and the sheath heater 110 having various structures can be used. As an example, a cross-sectional view of a mono-terminal type sheath heater 110 with a stripe-shaped heater wire 118 is shown in FIG.10A. FIG. 10B shows a cross-sectional view along a dashed line G1-G2 perpendicular to the long axis. FIG. 11A shows a cross-sectional view of the mono-terminal type sheath heater 110 with a stripe-shaped heater wire 118 having a spiral structure. FIG. 11B is a diagram showing a cross-sectional view along a chain line H1-H2 perpendicular to the long axis. FIG. 12A shows a cross-sectional view of the mono-terminal type sheath heater 110 with a stripe-shaped heater wire 118 having a double helix structure. FIG. 12B is a diagram showing a cross-sectional view along a chain line J1-J2 perpendicular to the long axis.

The sheath heater 110 shown in FIG. 10A differs from the sheath heater 110 shown in the first embodiment in that the stripe-shaped heater wire 118 is folded in the metal sheath 115 and that both ends thereof are taken out from one end of the metal sheath 115.

The cross-sectional shape of the sheath heater 110 illustrated in FIG. 10A is square, giving the stripe-shaped heater wires 118. As shown in FIG. 11A, the heater wire 118 is twisted in the metal sheath 115, where apart from the folded part to one end part and a part from the folded part to the other end part may each form a spiral structure independently. When the stripe-shaped heater wire 118 has a spiral structure, the spiral structure is adjusted so that the pitch L1 of the spiral is 1.0 mm or more and 3.0 mm or less, 1.0 mm or more and 2.5 mm or less, or 1.0 mm or more and 2.0 mm or less. By applying such a spiral structure, resistance of the sheath heater 110 can be increased by increasing the length of the heater wire 118 per unit length of the metal sheath 115. Furthermore, since it is possible to impart a spring property to the heater wire 118, disconnection during deformation and thermal expansion of the heater wire 118 is suppressed. Therefore, for example, even if the difference in thermal expansion coefficient between the metal sheath 115 and the heater wire 118 is large, it is possible to provide the sheath heater 110 with improved reliability.

As shown in FIG. 10B and FIG. 11B, the normal line of the heater wire 118 is substantially perpendicular to the direction in which the metal sheath 115 extends. Furthermore, in two parts of the heater wire 118 facing each other, the surface of the heater wire 118 is substantially parallel. Further, it is possible to maintain the distance g4 between the two parts of the heater wire 118 facing each other by setting the spiral direction of the spiral structure to be the same and adjusting the pitch L1 to also be substantially the same. As a result, it is possible to prevent a short circuit of the heater wire 118. However, the winding direction or pitches L1 of the spirals may be different from each other between the two parts of the heater wire 118 facing each other.

As shown in FIG. 12A, the heater wire 118 may be configured so that the two opposing parts of the heater wire 118 have a double helix structure. In this case, the heater wire 118 can be configured so that the pitch L2 of the spiral structure of the heater wire 118 is 1.0 mm or more and 6.0 mm or less, 1.0 mm or more and 2.5 mm or less, or 1.0 mm or more and 2.0 mm or less.

Referring to FIG. 10B, FIG. 11B, and FIG. 12B, the width d11 of the heater wire 118 can be selected from the range of 0.1 mm or more and 2.0 mm or less, and the thickness d12 can be selected from the range of 0.1 mm or more and 0.5 mm or less. The inner diameter d2 of the metal sheath 115 may be selected from the range of 3.0 mm or more and 4.0 mm or less, the thickness d4 may be selected from the range of 0.5 mm or more and 1.0 mm or less, and the outer diameter d3 may be selected from the range of 3.0 mm or more and 6.0 mm or less. The distance g3 between the heater wire 118 and the metal sheath 115 can be selected from the range of 0.3 mm or more and 1.0 mm or less, or 0.4 mm or more and 1.0 mm or less. The distance g4 between the part from the folded part to one end part of the heater wire 118 and the part from the folded part to the other end part is selected from the range of 0.3 mm or more 2.0 mm or less or 0.4 mm or more 1.0 mm or less. As a result, the sheath heater 110 can be formed thinner. Thus, it is possible to place the sheath heater 110 on the stage 100 with a high density. Therefore, it is possible to further reduce the temperature distribution of the substrate. Further, it is possible not only to ensure the insulation between the metal sheath 115 and the heater wire 118 but also prevent a short circuit of the heater wire 118.

There is no limitation to the shape of the cross-section perpendicular to the long axis of the sheath heater 110. For example, the shape of the cross-section perpendicular to the long axis of the sheath heater 110 may be a circular shape as shown in FIG. 1B and may be a polygonal shape or elliptical shape although not illustrated. When the cross-sectional shape is a circular shape, the force required for deformation does not depend on the direction of bending so that the sheath heater 110 can be readily bent in any direction. Therefore, it is possible to readily place the sheath heater 110 in the grooves formed in the first support plate 102 and the second support plate 104 as shown in FIG. 6B to FIG. 9.

### 6. Sixth Embodiment

In the present embodiment, a film forming apparatus and a film processing apparatus including the stage 100 or the stage 150 described above will be described. In the present embodiment, a film forming apparatus and a film processing apparatus provided with the stage 100 will be described as an example. Description of the same and similar configurations as those of the first to fifth embodiments may be omitted.

### 6-1. Etching Apparatus

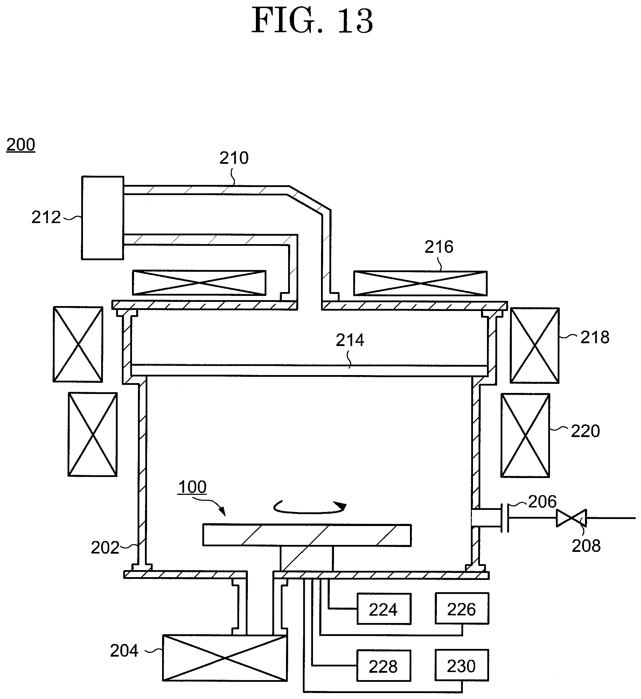

In FIG. 13, a cross-sectional view of an etching apparatus 200 which is one of the film processing apparatuses is shown. The etching apparatus 200 can perform dry etching on various films. The etching apparatus 200 includes a chamber 202. The chamber 202 provides a space for etching a film of a conductor, an insulator, a semiconductor, or the like formed on the substrate.

An exhaust apparatus 204 is connected to the chamber 202 so that the interior of the chamber 202 can be set to a reduced-pressure atmosphere. The chamber 202 is further provided with an introduction pipe 206 for introducing a reaction gas, and the reaction gas for etching is introduced into the chamber through a valve 208. Examples of the reactive gases include a fluorine-containing organic compound such as carbon tetrafluoride (CF₄), octafluorocyclobutane (c-C₄F₆), decafluorocyclopentane (c-C₅F₁₀), and hexafluorobutadiene (C₄F₆).

A microwave source 212 may be provided at the top of the chamber 202 via a waveguide 210. The microwave source 212 includes an antenna for supplying microwaves, and outputs high-frequency microwaves such as 2.45GHz microwaves and 13.56MHz radio waves. The microwaves generated at the microwave source 212 are transferred to the top of the chamber 202 by the waveguide 210 and are introduced into the chamber 202 through a window 214 containing quartz, ceramics, or the like. The reaction gas is converted into a plasma by the microwave, and etching of the film proceeds by electrons, ions, and radicals contained in the plasma.

In order to install a substrate on a lower part of the chamber 202, the stage 100 according to an embodiment of the present disclosure is provided. The substrate is placed on stage 100. A power supply 224 is connected to the stage 100 and a high frequency power is provided to the stage 100, by which a microwave electric field in a direction perpendicular to the substrate surface is formed on the surface of the stage 100. Further, a magnet 216, a magnet 218, and a magnet 220 can be provided on the top and side of the chamber 202. The magnet 216, the magnet 218, and the magnet 220 may be a permanent magnet, or an electromagnet having an electromagnetic coil. The magnet 216, the magnet 218 and the magnet 220 create magnetic field components parallel to the stage 100 and the substrate surfaces, and by the conjunction of electric fields generated by microwaves, the electrons in the plasma resonate under the Lorentz force and are bound to the stage 100 and the substrate surface. As a result, a high-density plasma can be generated on the substrate surface.

Further, a heater power supply 230 for controlling the sheath heater 110 provided on the stage 100 is connected to the stage 100. Further, as an optional configuration, a power supply 226 for an electrostatic chuck for fixing the substrate to the stage 100, a temperature controller 228 for controlling the temperature of the medium to be circulated inside the stage 100, and a rotating control apparatus (not illustrated) for rotating the stage 100 can be connected to the stage 100.

As described above, the stage 100 according to the embodiment of the present invention is used in the etching apparatus 200. By using the stage 100, the substrate can be uniformly heated and the heating temperature can be precisely controlled. Therefore, the etching apparatus 200 enables uniform etching of the various films provided on the substrate.

### 6-2. CVD Apparatus

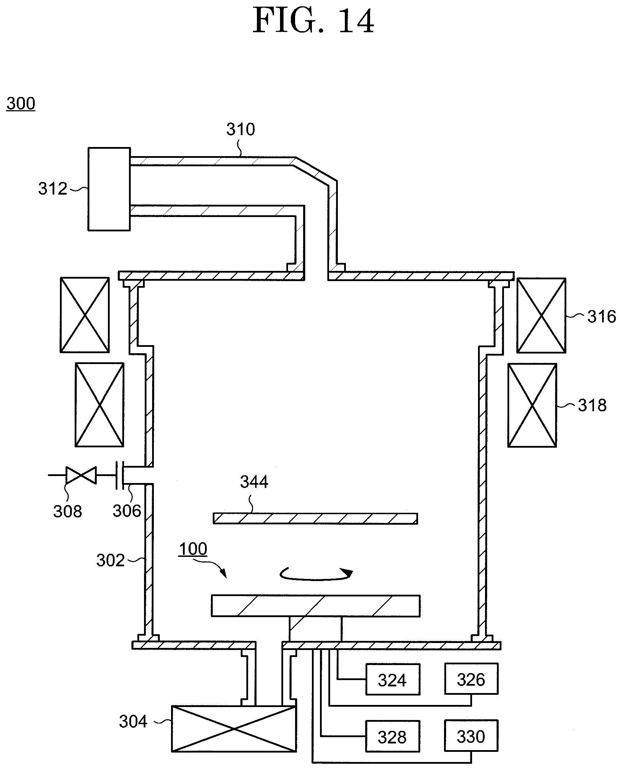

FIG. 14 shows a cross-sectional view of a CVD apparatus 300 which is one of the film-forming apparatuses. The CVD apparatus 300 includes a chamber 302. The CVD apparatus 300 provides a field for chemically reacting the reactant gases and chemically forming various films on the substrate.

An exhaust apparatus 304 is connected to the chamber 302 to reduce the pressure in the chamber 302. The chamber 302 is further provided with an introduction pipe 306 for introducing a reaction gas, and the reaction gas for film formation is introduced into the chamber 302 through a valve 308. Various gases can be used as the reaction gas depending on the film to be produced. The gas may be liquid at room temperature. For example, by using silane, dichlorosilane, tetraethoxysilane, or the like, a thin film such as silicon, silicon oxide, or silicon nitride can be formed. Alternatively, by using tungsten fluoride, trimethylaluminum, or the like, a thin metal film of tungsten, aluminum, or the like can be formed.

Similar to the etching apparatus 200, a microwave source 312 may be provided at an upper part of the chamber 302 via a waveguide 310. Microwaves generated by the microwave source 312 are introduced into the chamber 302 by the waveguide 310. The reaction gas is converted into a plasma by microwaves, and the chemical reaction of the gas is accelerated by various active species contained in the plasma, by which the products obtained by the chemical reaction are deposited on the substrate to form a thin film. Optionally, a magnet 344 may be provided in the chamber 302 to increase the density of the plasma. The stage 100 described in the first embodiment is provided at a lower part of the chamber 302, and thin films can be deposited while the substrate is placed on the stage 100. Similar to the etching apparatus 200, the side of the chamber 302 may be further provided with a magnet 316 and a magnet 318.

A heater power supply 330 for controlling the sheath heater 110 provided on the stage 100 is further connected to the stage 100. Optionally, a power supply 324 for providing high frequency power to the stage 100, a power supply 326 for the electrostatic chucking, a temperature controller 328 for controlling the temperature of the medium recirculated into the stage 100, and a rotating control apparatus (not shown) for rotating the stage 100, and the like can be connected to the stage 100.

### 6-3. Sputtering Apparatus

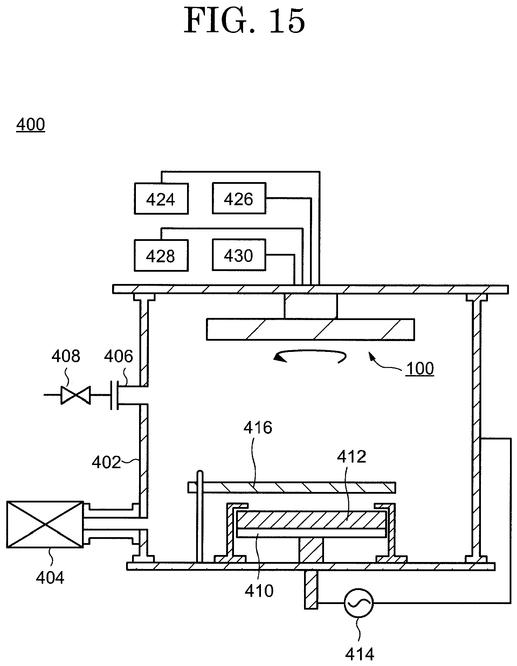

FIG. 15 shows a cross-sectional view of a sputtering apparatus 400 which is one of the film-forming apparatuses. The sputtering apparatus 400 includes a chamber 402. The sputtering apparatus 400 provides a field for collisions between fast ions and targets, and for depositing the target atoms that are generated at that time on the substrate.

An exhaust apparatus 404 for reducing the pressure in the chamber 402 is connected to the chamber 402. The chamber 402 is provided with an introduction tube 406 and a valve 408 for introducing a sputtering gas such as argon into the chamber 402.

A target stage 410 for holding a target containing a member to be deposited and functioning as a cathode is provided at a lower part of the chamber 402 over which a target 412 is provided. A high-frequency power supply 414 is connected to the target stage 410, and plasma can be generated in the chamber 402 by the high-frequency power supply 414.

The stage 100 described in the first embodiment may be provided at an upper part of the chamber 402. In this case, thin-film formation proceeds in a state where the substrate is placed underneath the stage 100. Similar to the etching apparatus 200 and the CVD apparatus 300, the heater power supply 430 is connected to the stage 100. A power supply 424 for providing a high frequency power to the stage 100, a power supply 426 for the electrostatic chucking, a temperature controller 428, and a rotating control apparatus (not illustrated) for rotating the stage 100 can be connected to the stage 100.

Argon ions accelerated by the plasma generated in the chamber 402 collide with the target 412, and atoms of the target 412 are ejected. The ejected atoms fly to and deposit on the substrate placed below the stage 100 while shutter 416 is open.

In the present embodiment, although a configuration is demonstrated in which the stage 100 is installed on the upper part of the chamber 402 and the target stage 410 is installed at the lower part of the chamber 40, the present embodiment is not limited to this configuration, and the sputtering apparatus 400 may be configured so that the target 412 is positioned on the stage 100. Alternatively, the stage 100 may be installed so that the main surface of the substrate is positioned perpendicular to the horizontal plane, and the target stage 410 may be provided so as to face the substrate.

6-4. Deposition Apparatus

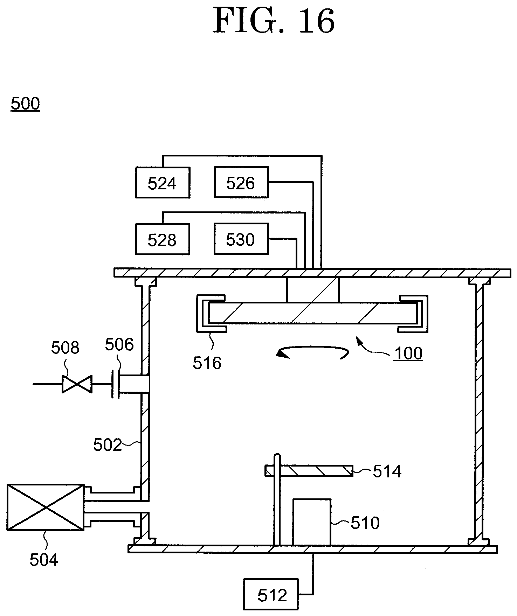

FIG. 16 shows a cross-sectional view of a deposition apparatus 500 which is one of the film-forming apparatuses. The deposition apparatus 500 includes a chamber 502. A space for the evaporation of the member at the deposition source 510 and for the deposition of the evaporated member on the substrate is provided by the chamber 502.

An exhaust apparatus 504 for providing a high vacuum in the chamber 502 is connected to the chamber 502. The chamber 502 is provided with an introduction pipe 506 for returning the chamber 502 to atmospheric pressure, and an inert gas such as nitrogen or argon is introduced into the chamber 502 through a valve 508.

A stage 100 may be provided at an upper part of the chamber 502. The depositions of members proceeds with the substrate placed underneath the state stage 100. Similar to the etching apparatus 200, the CVD apparatus 300, and the sputtering apparatus 400, the heater power supply 528 is further connected to the stage 100. Optionally, a power supply 524 for the electrostatic chucking, a temperature controller 526, and a rotating control apparatus 530 for rotating the stage 100 can be connected to the stage 100. The stage 100 may further include a mask holder 516 for fixing a metal mask between the substrate and the deposition source 510. This structure allows the metal mask to be placed in the vicinity of the substrate so that the opening part of the metal mask overlaps the region where the member is to be deposited.

A deposition source 510 is provided on a bottom part side of the chamber, and the member to be deposited is charged into the deposition source 510. The deposition source 510 is provided with a heater for heating the member, and the heater is controlled by a control apparatus 512. The evaporation is initiated by making the chamber 502 a highly vacuum state using the exhaust apparatus 504 and heating the evaporation source 510 to vaporize the member. The deposition of the member on the substrate is initiated by opening the shutter 514 when the deposition speed is constant.

As described above, the stages according to an embodiment of the present invention are used in a film-forming apparatus such as the CVD apparatus 300, the sputtering apparatus 400, or the deposition apparatus 500 of the present embodiment. By using these stages, it is possible to uniformly heat the substrate and precisely control the heating temperatures. Therefore, by using these film-forming apparatuses, various films whose properties are controlled can be uniformly formed on the substrate.

Each of the embodiments described above as an embodiment of the present invention can be appropriately combined and implemented as long as no contradiction is caused.

The invention is defined by the appended claims.

### REFERENCE SIGNS LIST

100: stage, 102: first support plate, 104: second support plate, 104-3: top surface, 104-4: bottom surface, 108: shaft, 109: region, 110: sheath heater, 110a: first sheath heater , 110b: second sheath heater, 110c: third sheath heater, 110d: fourth sheath heater, 112: lead wire, 114: terminal, 115: metal sheath, 116: first insulator, 118: heater wire, 120 : first groove, 122: first insulating member, 122a: first insulating member, 125: protruding member, 122b: first insulating member, 123: first through hole, 123a: first through hole , 123b: second through hole, 124: lid member, 124a: first hole, 124b: second hole, 128: second insulating member, 128a: second insulating member, 128b: second Insulator, 130: through hole, 132: third insulator, 136: second insulator, 140: second groove, 150: stage, 200: etching apparatus, 202: chamber, 204: exhaust apparatus, 206 : introduction tube, 208: valve, 210: waveguide tube, 212: microwave source, 214: window, 216: magnet, 218: magnet, 220: magnet, 224: power supply, 226: power supply, 228: temperature controller, 230: heater power supply, 300: CVD apparatus, 302: chamber, 304: exhaust apparatus, 306: introduction tube, 308: valve, 310: waveguide tube, 312: microwave source, 316: magnet, 318: magnet, 324: power supply, 326: power supply, 328: temperature controller, 330: heater power supply, 344: magnet, 400: sputter apparatus, 402: chamber, 404: exhaust apparatus, 406: introduction tube, 408: valve, 410: target stage, 412: target, 414: high frequency power supply, 416: shutter, 424: power supply, 426: power supply, 428: temperature controller, 430: heater power supply, 500: deposition apparatus, 502: chamber, 504: exhaust apparatus, 506: introduction tube, 508: valve, 510: vapor deposition source, 512: control apparatus, 514: shutter, 516: mask holder, 524: power supply, 526: temperature controller, 528: heater power supply, 530: rotation control apparatus

## Claims

1. A heater (110) comprising:
a folded heater wire (118);
a first insulator (116) provided on the heater wire (118);
a metal sheath (115) provided so as to be in contact with at least a part of the first insulator (116);
a first insulating member (122) arranged parallel to at least a part of one of the heater wire (118) taken out from a first end part of the metal sheath (115);
a second insulating member (128) arranged parallel to at least a part of the first insulating member (122) and parallel to at least a part of the other of the heater wire (118) taken out from the first end part of the metal sheath (115);
a second insulator (136) in contact with at least a part of the first insulating member (122), at least a part of the second insulating member (128) and at least a part of the metal sheath (115); the heater (110) being **characterized in that** it further comprises
a lid member (124) covering a part of the first insulating member (122), the lid member (124) being connected to at least a part of the metal sheath (115), at least a part of the first insulating member (122) and at least a part of the second insulating member (128) via the second insulator (136), and arranged parallel to at least a part of the first insulating member (122), at least a part of the second insulating member (128) and at least a part of the metal sheath (115),
wherein
the lid member (124) has an inwardly recessed structure,
the second insulator (136) is in contact with a part of the inside of the lid member (124),
the lid member (124) is fitted to the first insulating member (122) via the second insulator (136).

2. The heater (110) according to claim 1, wherein
the lid member (124) is composed of one member having a predetermined thickness.

3. The heater (110) according to claim 1, wherein
an inner diameter of the lid member (124) is substantially the same as an outer diameter of the first insulating member (122), and an outer diameter of the lid member (124) is substantially the same as an outer diameter of the metal sheath (115).

4. The heater (110) according to claim 1, wherein
an inner diameter of the metal sheath (115) is substantially the same as an outer diameter of the first insulating member (122), and the first insulating member (128a) is inserted through the metal sheath (115).

5. The heater (110) according to claim 1, wherein
the first insulating member (122) has a protruding member (125), and the lid member (124) fits into the protruding member (125) via the second insulator (136).

6. The heater (110) according to claim 1, wherein
the protruding member (125) protrudes in a direction opposite to a direction in which the metal sheath (115) is provided.

7. The heater (110) according to claim 1, wherein
the first insulating member (122) has a through hole, and the second insulating member (128) is inserted through the through hole.

8. The heater (110) according to claim 7, wherein
a diameter of the through hole in the top part side of the first insulating member (122) is different from that of the bottom part side of the first insulating member (122).

9. The heater (110) according to claim 8, wherein
the cross-section of the through hole has a stair shape at a connecting part having different hole diameter,
the second insulating member (128) is inserted to the connecting part.

10. The heater (110) according to claim 1, wherein
a shape of the heater wire (118) is strip-shaped.

11. The heater (110) according to claim 1, wherein
the heater wire (118) has a spiral structure.

12. The heater (110) according to claim 1, wherein
the heater wire (118) has a double helix structure.

13. The heater (110) according to claim 1, wherein
the second insulator (136) is a sealant or an adhesive.

14. The heater (110) according to claim 1, wherein
the metal sheath (115) includes aluminum.

15. The heater (110) according to claim 1, wherein
the outer diameter of the metal sheath (115) is 3.0 mm or more and 6.0 mm or less.

16. The heater (110) according to claim 1, wherein
the lid member (124) includes aluminum.

17. The heater (110) according to claim 1, wherein
an outer diameter of the lid member (124) is 3.0 mm or more and 6.0 mm or less.

## Patentansprüche

1. Heizgerät (110), umfassend:
einen gefalteten Heizdraht (118);
einen ersten Isolator (116), der sich auf dem Heizdraht (118) befindet;
eine Metallummantelung (115), die so angeordnet ist, dass sie sich in Kontakt mit wenigstens einem Teil des ersten Isolators (116) befindet;
ein erstes isolierendes Element (122), das parallel zu wenigstens einem Teil des einen Heizdrahtes (118), das aus einem ersten Endteil der Metallummantelung (115) herausgeführt ist, angeordnet ist;
ein zweites isolierendes Element (128), das parallel zu wenigstens einem Teil des ersten isolierenden Elements (122) und parallel zu wenigstens einem Teil des anderen Heizdrahtes (118), das aus einem ersten Endteil der Metallummantelung (115) herausgeführt ist, angeordnet ist;
einen zweiten Isolator (136) in Kontakt mit wenigstens einem Teil des ersten isolierenden Elements (122), wenigstens einem Teil des zweiten isolierenden Elements (128) und wenigstens einem Teil der Metallummantelung (115); wobei das Heizgerät (110) **dadurch gekennzeichnet ist, dass** es weiterhin Folgendes umfasst:
ein Deckelelement (124), das einen Teil des ersten isolierenden Elements (122) abdeckt, wobei das Deckelelement (124) über den zweiten Isolator (136) mit wenigstens einem Teil der Metallummantelung (115), wenigstens einem Teil des ersten isolierenden Elements (122) und wenigstens einem Teil des zweiten isolierenden Elements (128) verbunden ist und parallel zu wenigstens einem Teil des ersten isolierenden Elements (122), wenigstens einem Teil des zweiten isolierenden Elements (128) und wenigstens einem Teil der Metallummantelung (115) angeordnet ist,
wobei
das Deckelelement (124) eine nach innen vertiefte Struktur aufweist,
sich der zweite Isolator (136) mit einem Teil des Innern des Deckelelements (124) in Kontakt befindet,
das Deckelelement (124) über den zweiten Isolator (136) am ersten isolierenden Element (122) befestigt ist.

2. Heizgerät (110) gemäß Anspruch 1, wobei
das Deckelelement (124) aus genau einem Element mit einer vorbestimmten Dicke besteht.

3. Heizgerät (110) gemäß Anspruch 1, wobei
ein Innendurchmesser des Deckelelements (124) im Wesentlichen gleich einem Außendurchmesser des ersten isolierenden Elements (122) ist und ein Außendurchmesser des Deckelelements (124) im Wesentlichen gleich einem Außendurchmesser der Metallummantelung (115) ist.

4. Heizgerät (110) gemäß Anspruch 1, wobei
ein Innendurchmesser der Metallummantelung (115) im Wesentlichen gleich einem Außendurchmesser des ersten isolierenden Elements (122) ist und das erste isolierende Element (128a) durch die Metallummantelung (115) hindurch eingefügt wird.

5. Heizgerät (110) gemäß Anspruch 1, wobei
das erste isolierende Element (122) ein hervorstehendes Element (125) aufweist und das Deckelelement (124) über den zweiten Isolator (136) an das hervorstehende Element (125) angepasst ist.

6. Heizgerät (110) gemäß Anspruch 1, wobei
das hervorstehende Element (125) in einer Richtung hervorsteht, die der Richtung, in der die Metallummantelung (115) bereitgestellt wird, entgegengesetzt ist.

7. Heizgerät (110) gemäß Anspruch 1, wobei
das erste isolierende Element (122) ein Durchgangsloch aufweist und das zweite isolierende Element (128) durch das Durchgangsloch eingefügt wird.

8. Heizgerät (110) gemäß Anspruch 7, wobei
ein Durchmesser des Durchgangslochs auf der Oberseite des ersten isolierenden Elements (122) von dem der Unterseite des ersten isolierenden Elements (122) verschieden ist.

9. Heizgerät (110) gemäß Anspruch 8, wobei
der Querschnitt des Durchgangslochs an einem Verbindungsteil, das einen unterschiedlichen Lochdurchmesser hat, eine Stufenform aufweist,
das zweite isolierende Element (128) in das Verbindungsteil eingefügt wird.

10. Heizgerät (110) gemäß Anspruch 1, wobei
der Heizdraht (118) streifenförmig ist.

11. Heizgerät (110) gemäß Anspruch 1, wobei
der Heizdraht (118) eine Spiralstruktur aufweist.

12. Heizgerät (110) gemäß Anspruch 1, wobei
der Heizdraht (118) eine Doppelspiralstruktur aufweist.

13. Heizgerät (110) gemäß Anspruch 1, wobei
der zweite Isolator (136) ein Dichtungsmittel oder ein Klebstoff ist.

14. Heizgerät (110) gemäß Anspruch 1, wobei
die Metallummantelung (115) Aluminium umfasst.

15. Heizgerät (110) gemäß Anspruch 1, wobei
der Außendurchmesser der Metallummantelung (115) 3,0 mm oder mehr und 6,0 mm oder weniger beträgt.

16. Heizgerät (110) gemäß Anspruch 1, wobei
das Deckelelement (124) Aluminium umfasst.

17. Heizgerät (110) gemäß Anspruch 1, wobei
ein Außendurchmesser des Deckelelements (124) 3,0 mm oder mehr und 6,0 mm oder weniger beträgt.

## Revendications

1. Appareil de chauffage (110), comprenant :
un fil chauffant plié (118) ;
un premier isolateur (116) situé sur le fil chauffant (118) ;
une gaine métallique (115) située de telle manière qu'elle soit en contact avec au moins une partie du premier isolateur (116) ;
un premier élément isolant (122) disposé parallèlement à au moins une partie de l'un des fils chauffants (118) sorti d'une première extrémité de la gaine métallique (115) ;
un deuxième élément isolant (128) disposé parallèlement à au moins une partie du premier élément isolant (122) et parallèlement à au moins une partie de l'autre fil chauffant (118) sorti de la première extrémité de la gaine métallique (115) ;
un deuxième isolateur (136) en contact avec au moins une partie du premier élément isolant (122), au moins une partie du deuxième élément isolant (128) et au moins une partie de la gaine métallique (115) ; ledit appareil de chauffage (110) étant **caractérisé en ce qu'**il comprend en outre
un élément de couvercle (124) couvrant une partie du premier élément isolant (122),ledit élément de couvercle (124) étant raccordé à au moins une partie de la gaine métallique (115), au moins une partie du premier élément isolant (122) et au moins une partie du deuxième élément isolant (128) par l'intermédiaire du deuxième isolateur (136), et disposé parallèlement à au moins une partie du premier élément isolant (122), au moins une partie du deuxième élément isolant (128) et au moins une partie de la gaine métallique (115),
où
ledit élément de couvercle (124) présente une structure en retrait vers l'intérieur,
le deuxième isolateur (136) est en contact avec une partie de l'intérieur de l'élément de couvercle (124),
l'élément de couvercle (124) est monté sur le premier élément isolant (122) par l'intermédiaire du deuxième isolateur (136).

2. Appareil de chauffage (110) selon la revendication 1, dans lequel
l'élément de couvercle (124) est composé d'un seul élément ayant une épaisseur prédéterminée.

3. Appareil de chauffage (110) selon la revendication 1, dans lequel
un diamètre intérieur de l'élément de couvercle (124) est sensiblement égal à un diamètre extérieur du premier élément isolant (122), et un diamètre extérieur de l'élément de couvercle (124) est sensiblement égal à un diamètre extérieur de la gaine métallique (115).

4. Appareil de chauffage (110) selon la revendication 1, dans lequel
un diamètre intérieur de la gaine métallique (115) est sensiblement égal à un diamètre extérieur du premier élément isolant (122), et le premier élément isolant (128a) est inséré à travers la gaine métallique (115).

5. Appareil de chauffage (110) selon la revendication 1, dans lequel
le premier élément isolant (122) possède un élément saillant (125), et l'élément de couvercle (124) est engagé dans l'élément saillant (125) par l'intermédiaire du deuxième isolateur (136).

6. Appareil de chauffage (110) selon la revendication 1, dans lequel
l'élément saillant (125) fait saillie dans une direction opposée à une direction dans laquelle la gaine métallique (115) est fournie.

7. Appareil de chauffage (110) selon la revendication 1, dans lequel
le premier élément isolant (122) possède un trou traversant, et le deuxième élément isolant (128) est inséré à travers le trou traversant.

8. Appareil de chauffage (110) selon la revendication 7, dans lequel
un diamètre du trou traversant au côté supérieur du premier élément isolant (122) est différent de celui du côté inférieur du premier élément isolant (122).

9. Appareil de chauffage (110) selon la revendication 8, dans lequel
la section transversale du trou traversant présente une forme etagée au niveau d'une pièce de raccordement ayant un diamètre de trou différent,
le deuxième élément isolant (128) est inséré dans la pièce de raccordement.

10. Appareil de chauffage (110) selon la revendication 1, dans lequel
ledit fil chauffant (118) présente une forme en bande.

11. Appareil de chauffage (110) selon la revendication 1, dans lequel
ledit fil chauffant (118) présente une structure hélicoïdale.

12. Appareil de chauffage (110) selon la revendication **1,** dans lequel
ledit fil chauffant (118) présente une structure en double hélice.

13. Appareil de chauffage (110) selon la revendication **1,** dans lequel
le deuxième isolateur (136) est un agent d'étanchéité ou un adhésif.

14. Appareil de chauffage (110) selon la revendication **1,** dans lequel
la gaine métallique (115) comprend de l'aluminium.

15. Appareil de chauffage (110) selon la revendication **1,** dans lequel
le diamètre extérieur de la gaine métallique (115) est 3,0 mm ou plus et 6,0 mm ou moins.

16. Appareil de chauffage (110) selon la revendication **1,** dans lequel
l'élément de couvercle (124) comprend de l'aluminium.

17. Appareil de chauffage (110) selon la revendication **1,** dans lequel
un diamètre extérieur de l'élément de couvercle (124) est 3,0 mm ou plus et 6,0 mm ou moins.
